# FASCICULE DE BREVET EUROPEEN

(11) **EP 3 257 808 B1**
(45) Date de publication et mention de la délivrance du brevet: **11.05.2022**
(21) Numéro de dépôt: 17176388.1
(22) Date de dépôt: 16.06.2017
(51) Int. Cl.: B81B 3/00

(54) **DISPOSITIF MICROELECTROMECANIQUE ET/OU NANOELECTROMECANIQUE A DEPLACEMENT HORS-PLAN COMPORTANT DES MOYENS CAPACITIFS A VARIATION DE SURFACE**
MIKROELEKTROMECHANISCHE UND/ODER NANOELEKTROMECHANISCHE VORRICHTUNG MIT BEWEGUNG AUSSERHALB DER EBENE, DIE MIT KAPAZITIVEN MITTELN ZUR ÄNDERUNG DER OBERFLÄCHE AUSGESTATTET IST
MICROELECTROMECHANICAL AND/OR NANOELECTROMECHANICAL DEVICE WITH OUT-OF-PLANE MOVEMENT HAVING CAPACITIVE MEANS WITH SURFACE VARIATION

(30) Priorité: 17.06.2016 FR 1655653
(43) Date de publication de la demande: 20.12.2017
(73) Titulaire: Commissariat à l'énergie atomique et aux énergies alternatives, 75015 Paris (FR)
(72) Inventeur: MASPERO, Federico, 38100 Grenoble (FR); JOET, Loïc, 38000 Grenoble (FR)
(74) Mandataire: Brevalex

(56) Documents cités:
- EP-A1- 2 599 746
- WO-A2-2010/038229
- DE-A1-102012 223 016
- US-A1- 2003 210 511
- US-A1- 2010 225 255
- US-A1- 2016 138 920
- US-B1- 6 384 952

## Description

### DOMAINE TECHNIQUE ET ÉTAT DE LA TECHNIQUE ANTÉRIEURE

La présente invention se rapporte à un dispositif MEMS et/ou NEMS à mouvement hors-plan comportant des moyens capacitifs à variation de surface, pouvant servir de capteur ou d'actionneur.

Les dispositifs microélectromécanique ou MEMS (Microelectromechanical Systems en terminologie anglo-saxonne) et les dispositifs nanoélectromécanique ou NEMS (Nanoelectromechanical Systems en terminologie anglo-saxonne) sont de plus en plus présents dans les objets du quotidien tels que les téléphones portables, type smartphone, les tablettes tactiles et les montres intelligentes. Ces dispositifs sont utilisés en tant que capteurs, par exemple comme capteurs inertiels et en tant que micro ou nanoactionneur.

Par ailleurs, du fait de la production de masse de ces dispositifs et leur besoins d'intégration, il en résulte une réduction des dimensions de ces dispositifs. Les dimensions ont été par exemple divisées par 10 environ dans les dernières années.

Cette réduction de taille peut poser des problèmes. En effet dans le cas de capteurs inertiels la réduction de la masse inertielle provoque une augmentation du bruit mécanique puisqu'il est plus affecté par les forces browniennes du déplacement de l'air. En outre dans le cas de détection capacitive qui est le cas d'un grand nombre de capteurs inertiels, la réduction de l'emprise du capteur a pour effet de réduire la capacité statique ou au repos, rendant le dispositif plus sensible aux capacités parasites.

En général, les moyens capacitifs de détection de mouvement dans le plan comportent des peignes interdigités. Souvent, la détection hors plan ne se fait que par deux surfaces en regard, l'un des peignes étant fixe par rapport à une partie fixe et l'autre peigne étant fixé à la masse mobile. Le déplacement relatif des peignes peut être à variation d'entrefer ou à variation de surface. Dans le cas d'une variation d'entrefer, les doigts de peignes se déplacent perpendiculairement à leur surface et la variation de capacité est due à la variation de l'entrefer entre les doigts en regard. Dans le cas d'une variation de surface, les doigts se déplacent dans une direction parallèle au plan de leur surface et la variation de capacité est due à la variation des surfaces des doigts en regard. Les moyens capacitifs de détection de mouvement hors-plan sont en général à variation d'entrefer. Ils comportent deux surfaces en regard perpendiculaires à la direction des mouvements hors-plan et dont l'entrefer varie en fonction des mouvements.

Les dispositifs capacitifs à variation d'entrefer présentent plusieurs inconvénients.

Ils présentent une résolution et une sensibilité limitées du fait de la non-linéarité du procédé de transduction. Ils peuvent présenter un coefficient d'amortissement important du à la couche d'air qui est écrasée entre les surfaces en regard, il en résulte alors un bruit mécanique. En outre, il existe un risque accru de collage des surfaces en regard du au phénomène de pull-in.

Il est alors préférable d'utiliser des moyens capacitifs à variation de surface.

Le document US2009/0308160 décrit un accéléromètre à déplacement hors-plan à détection capacitive à variation de surface. Sur la figure 12, on peut voir reproduit schématiquement l'accéléromètre de la figure 9 du document US2009/0308160. Il comporte une partie mobile 2001 suspendue par des ressorts à une partie fixe. La partie mobile 2001 comporte une masse 2002 fixée à une partie de support d'électrodes 2004 par une portion de couplage 2009 en oxyde. Afin de pouvoir détecter le sens de déplacement de la partie mobile, cet accéléromètre nécessite la mise en œuvre d'électrodes de taille différente. La partie de support d'électrodes 2004 comporte des premières électrodes mobiles 2005 d'une première taille et des deuxièmes électrodes mobiles 2006 d'une deuxième taille. La partie fixe comporte des premières électrodes fixes 2007 d'une première taille et des deuxièmes électrodes fixes 2008 d'une deuxième taille. Les électrodes 2005 et 2007 sont interdigitées et les électrodes 2006 et 2008 sont interdigitées.

Les premières électrodes interdigitées 2005, 2007 détectent uniquement un mouvement de la partie mobile vers le haut et les deuxièmes électrodes interdigitées 2006, 2008 détectent uniquement un mouvement de la partie mobile vers le bas. Ces deux groupes d'électrodes étant réalisés séparément, il existe des différences entre les électrodes, ce qui conduit à la génération d'un signal de détection non symétrique, il en résulte alors une non linéarité importante. En outre, la sensibilité est réduite par rapport à un dispositif dans lequel toutes les électrodes participeraient à la détection dans les deux sens de déplacement.

De plus cet accéléromètre est de structure et de réalisation complexes, en effet les peignes ne sont pas directement fixés sur la masse mais ils sont fixés sur un support qui lui-même est relié à la masse par des bras rigides. La mise en œuvre de ces éléments intermédiaire réduit la surface disponible pour les électrodes. Par ailleurs la réalisation d'électrodes de taille différentes est complexe.

Par ailleurs, la partie mobile présente un certain encombrement, il en résulte que l'accéléromètre présente également un certain encombrement.

En outre la structure de cet accéléromètre ne peut être utilisée comme actionneur hors-plan, car quel que soit la direction de déplacement les capacités diminuent. D'autres exemples de tels dispositifs sont présentés dans les documents WO2010/038229, US2010225255 et US2003/210511.

Le document EP2599746 décrit un procédé relatif présentant les étapes de dépôt de SiO₂ sur un substrat conductif, définition d'une zone poreuse suivie de l'élimination d'un masque et un recouvrement par une couche de silicium, suivie par la définition d'une première zone suspendue. Par la suite, une couche de SiO₂ est formée, suivie par le scellement d'un autre substrat,puis par la formation et la libération des structures mobiles.

### EXPOSÉ DE L'INVENTION

C'est par conséquent un but de la présente invention d'offrir un dispositif MEMS et/ou NEMS à mouvement hors-plan, pouvant servir de dispositif de détection et/ou d'actionneur, comportant des moyens capacitifs à variation de surface de réalisation aisée tout en offrant une linéarité et une sensibilité améliorées.

Le but énoncé ci-dessus est atteint par un dispositif MEMS et/ou NEMS tel que décrit dans la revendication 1, comportant au moins une première partie et une deuxième partie mobiles l'une par rapport à l'autre de sorte à pouvoir se déplacer dans une direction hors-plan, la première partie comportant au moins des premières électrodes s'étendant parallèlement à la direction de déplacement, la deuxième partie comportant un deuxième support et au moins des deuxièmes électrodes s'étendant parallèlement à la direction de déplacement de la deuxième partie, les premières et deuxièmes électrodes étant disposées les unes par rapport aux autres de sorte à être interdigitées, le deuxième support comportant au moins une face perpendiculaire à la direction de déplacement hors-plan, au moins une partie des deuxième électrodes comportant une première extrémité et une deuxième extrémité dans la direction de déplacement hors-plan, la deuxième extrémité étant directement connectée à la face du deuxième support et la première extrémité étant disposée entre deux premières électrodes de sorte qu'une partie seulement de la face de chaque première électrode soit en regard d'une deuxième électrode au repos.

Dans le cas d'un dispositif inertiel, le deuxième support est formé au moins en partie par une masse inertielle.

Toutes les électrodes participent à la détection du déplacement relatif des première et deuxième parties que soit le sens du déplacement, la sensibilité de détection n'est donc pas réduite. En outre, par exemple dans le cas où l'une des parties est fixe et l'autre mobile, la structure du dispositif selon l'invention permet de détecter le sens de déplacement hors-plan de la partie mobile même dans le cas où les électrodes sont toutes de mêmes dimensions.

La structure peut être simplifiée.

De plus toute la face du deuxième support peut être occupée par les électrodes, une grande densité d'électrodes peut être atteinte. Le dispositif peut présenter une forte densité capacitive. Il offre en outre une bonne linéarité et bonne sensibilité grâce à la détection par variation de surface.

Par ailleurs, l'invention permet d'avoir une masse inertielle importante et donc une force inertielle importante ce qui est avantageux dans le cas de dispositifs de détection. La taille du dispositif peut être réduite sans diminuer ses performances. En outre, l'invention permet de réduire la masse inertielle et donc réduire davantage l'encombrement du dispositif tout en conservant des performances similaires car la sensibilité est augmentée et le bruit électronique est plus masqué, ce qui peut compenser l'augmentation de bruit résultant de la réduction de la masse inertielle.

Les électrodes étant directement fixées à la masse, le dispositif présente une compacité améliorée. En effet on évite la mise en œuvre de cadre encombrant pour maintenir les électrodes et qui ne participent pas directement au fonctionnement. En outre les électrodes présentent une rigidité suffisante car elles sont courtes.

En d'autres termes, on réalise un dispositif MEMS et/ou NEMS comportant au moins deux parties mobiles l'une par rapport à l'autre, dans lequel au moins une partie des électrodes de l'une des partie s'étend directement de l'une des faces de celle-ci. Au repos les électrodes sont alors décalées par rapport aux électrodes de l'autre partie dans la direction de déplacement hors-plan et permettent en coopération avec les électrodes de l'autre partie, soit de détecter le déplacement hors-plan et le sens du déplacement, soit de provoquer un déplacement entre les deux parties en appliquant une différence de potentiel entre les électrodes.

Cette structure permet d'utiliser le dispositif soit comme dispositif de détection, par exemple comme accéléromètre, soit comme actionneur, par exemple pour déplacer des micromiroirs.

Dans un mode de réalisation, le dispositif comporte un ensemble comprenant une premier et une deuxième partie mobiles l'une par rapport à l'autre et un deuxième ensemble comportant une première et une deuxième partie mobiles l'une par rapport à l'autre, la première partie du premier ensemble étant reliée mécaniquement à la deuxième partie du deuxième ensemble et la deuxième partie du premier ensemble étant reliée mécaniquement à la première partie du deuxième ensemble.

Dans un exemple de procédé de fabrication, deux couches sont mises en œuvre, l'une pour réaliser la masse et l'autre pour réaliser les électrodes. On peut donc utiliser une couche épaisse pour avoir une masse importante, et une couche plus fine pour réaliser les électrodes, ce qui permet de graver des entrefers très fins.

La présente invention a alors pour objet un dispositif microélectromécanique et/ou nanoélectromécanique tel que défini dans la revendication 1.

Dans un mode de réalisation, au moins une desdites première ou deuxième parties est mobile et l'autre desdites première ou deuxième parties est fixe.

Dans un autre mode de réalisation, les première ou deuxième parties sont toutes les deux mobiles et se déplacent l'une par rapport à l'autre

Selon l'invention au moins les deuxièmes électrodes de la deuxième partie, qu'elle soit fixe ou mobile, sont ancrées au deuxième support par leur deuxième extrémités tandis que la première partie qu'elle soit fixe ou mobile peut comporter des premières électrodes suspendues au premier support, i.e. leurs extrémités ne sont pas en contact direct avec le premier support, ou ancrées, i.e. leurs extrémités sont en contact direct avec le premier support.

La première et/ou la deuxième partie étant mobiles, une partie au moins dudit premier et/ou dudit deuxième support peuvent former une masse inertielle.

La partie du premier support formant une masse inertielle peut être suspendue à la deuxième partie et/ou la partie du deuxième support formant une masse inertielle peut être suspendue à la première partie.

Dans un exemple avantageux, le dispositif comporte au moins deux ensembles, un ensemble désigné premier ensemble et un ensemble désigné deuxième ensemble, la première partie du premier ensemble étant reliée mécaniquement à la deuxième partie du deuxième ensemble, et la deuxième partie du premier ensemble étant mécaniquement reliée à la première partie du deuxième ensemble.

De préférence, la première partie du premier ensemble et la deuxième partie du deuxième ensemble sont isolées électriquement l'une de l'autre, et/ou la deuxième partie du premier ensemble et la première partie du deuxième ensemble sont isolées électriquement l'une de l'autre. Ce dispositif permet de réaliser une lecture différentielle.

Avantageusement, le deuxième support du premier ensemble et le deuxième support du deuxième ensemble sont situés à l'opposé du premier support du premier ensemble et du premier support du deuxième ensemble par rapport à un plan perpendiculaire à la direction hors-plan.

Dans un autre exemple de réalisation, le deuxième support formant masse inertielle du premier ensemble entoure le deuxième support du deuxième ensemble, et la première partie du premier ensemble comporte au moins deux portions suspendues polarisables séparément et disposées de manière symétrique par rapport à un plan de symétrie du dispositif contenant la direction de déplacement hors-plan.

Dans un autre exemple de réalisation, le deuxième support formant masse inertielle du premier ensemble comporte quatre logements pour recevoir quatre deuxièmes supports du deuxième ensemble, les deuxièmes électrodes du premier ensemble forment une croix entre les quatre logements, et le deuxième ensemble comporte quatre premiers supports suspendus au deuxième support du premier ensemble.

De manière avantageuse, pour chaque ensemble, les premières électrodes et les deuxièmes électrodes ont une section transversale telle que les premières ou les deuxièmes électrodes entourent les deuxièmes ou les premières électrodes respectivement de manière continue.

Le dispositif selon l'invention peut former un dispositif de détection capacitive.

Le dispositif selon l'invention peut former un actionneur. La partie mobile est par exemple suspendue à la partie fixe par une articulation pivot.

La présente invention a également pour objet un dispositif à micromiroir comportant au moins un actionneur selon l'invention, le support mobile comportant une deuxième face opposée à la première face, comportant une surface réfléchissante formant miroir.

Le dispositif selon l'invention peut former un gyromètre comportant au moins un dispositif selon l'invention formant un actionneur et/ou un dispositif de détection.

La présente invention a également pour objet un procédé de fabrication d'un dispositif selon la revendication 16 à partir d'un premier substrat comportant au moins une première couche en matériau conducteur électrique épaisse, comportant les étapes :
a) formation d'une couche sacrificielle, par exemple en oxyde sur la première couche en matériau conducteur électrique,
b) formation de premières tranchées dans la première couche sacrificielle jusqu'à la première couche en matériau conducteur électrique de sorte à former des îlots de seconde couche sacrificielle,
c) formation d'une deuxième couche de matériau conducteur électrique sur la première couche sacrificielle et dans les premières tranchées,
d) structuration de ladite deuxième couche en matériau conducteur électrique de sorte à former des deuxièmes tranchées débouchant au moins en partie_sur les îlots de deuxième couche sacrificielle, l'élément ainsi formé comportant des premières portions de la deuxième couche en matériau conducteur électrique en contact avec la première couche en matériau conducteur électrique et destinées à former les deuxièmes électrodes et des deuxièmes portions de la deuxième couche de matériau conducteur électrique en contact avec les ilots de deuxième couche sacrificielle, destinées à former les premières électrodes,
e) gravure partielle des premières portions,
f) libération de la structure.

De manière très avantageuse, lors de l'étape d), les premières électrodes sont formées par une gravure arrêtée sur les ilots de deuxième couche sacrificielle et les deuxièmes électrodes sont formées par cette même gravure arrêtée au temps avec arrêt entre les ilots de deuxième couche sacrificielle ou au-delà dans le sens de la gravure.

L'étape d) peut comporter la formation d'un masque dur sur la deuxième couche de matériau conducteur électrique, la structuration dudit masque dur aux emplacements des deuxièmes portions, et la formation d'un masque en résine photosensible aux emplacements des premières portions.

Avantageusement, l'étape c) comporte une étape de croissance par épitaxie.

Dans un exemple de réalisation, le procédé comporte entre l'étape e) et l'étape f) la réalisation d'un deuxième substrat muni d'une cavité, d'assemblage du deuxième substrat avec le premier substrat de sorte que les premières et deuxièmes portions soient en regard de la cavité et de réalisation de troisièmes tranchées dans le premier substrat à partir de la face arrière jusqu'à la première couche sacrificielle, de sorte à délimiter la partie mobile.

Le procédé peut avantageusement comporter une étape d'assemblage d'un capot sur le deuxième substrat.

Dans un autre exemple de réalisation, le premier substrat est un substrat silicium sur isolant et le procédé de fabrication comporte préalablement à l'étape a) la formation de quatrièmes tranchées dans la première couche en matériau conducteur électrique jusqu'à une couche d'oxyde du premier substrat de sorte à délimiter la partie mobile, et dans lequel lors de l'étape a) la première couche sacrificielle est formée sur la première couche en matériau conducteur électrique de sorte à recouvrir la première couche en matériau conducteur électrique et à au moins obturer les quatrièmes tranchées.

### BRÈVE DESCRIPTION DES DESSINS

La présente invention sera mieux comprise sur la base de la description qui va suivre et des dessins en annexe sur lesquels:
- la figure 1A est une vue d'un exemple de réalisation d'un dispositif MEMS et/ou NEMS ne faisant pas partie de l'invention,
- la figure 1B est une vue en coupe du dispositif de la figure A selon le plan de coupe A-A,
- la figure 2 est une vue de détail de la figure 1A au niveau des électrodes,
- la figure 3A est une vue d'un autre exemple de réalisation du dispositif MEMS et/ou NEMS selon l'invention,
- la figure 3B est une vue en coupe du dispositif de la figure 3A selon le plan de coupe B-B,
- la figure 4A est une vue d'un exemple de réalisation du dispositif MEMS et/ou NEMS selon l'invention,
- la figure 4B est une vue en coupe du dispositif de la figure 4A selon le plan de coupe C-C,
- la figure 5 est une vue de dessus d'un autre exemple de réalisation d'un dispositif MEMS et/ou NEMS selon l'invention,
- les figures 6 et 7 sont des variantes de réalisation du dispositif de la figure 5,
- les figures 8A à 8C sont des vues de dessus d'exemple de réalisation d'électrodes,
- la figure 9A est une vue de dessus d'un exemple de réalisation du dispositif MEMS et/ou NEMS selon l'invention particulièrement adapté à la réalisation d'un actionneur, dans lequel le substrat a été omis,
- la figure 9B est une vue en coupe du dispositif de la figure 9A selon le plan de coupe D-D,
- les figures 10A à 10I sont des représentations schématiques d'étapes de réalisation d'un exemple de procédé de réalisation du dispositif selon l'invention,
- la figure 10G' est une représentation schématique d'une variante de réalisation des électrodes par gravure,
- les figures 11A à 11I sont des représentations schématiques d'étapes de réalisation d'un autre exemple de procédé de réalisation du dispositif selon l'invention,
- la figure 12 est une représentation schématique d'un accéléromètre de l'état de la technique,
- la figure 13 est une représentation en perspective d'un capteur inertiel selon l'invention mettant en œuvre les moyens de guidage,
- les figures 14A et 14B sont des représentations du capteur de la figure 13 dans deux états différents,
- la figure 15A est une représentation d'un dispositif mettant en œuvre des moyens de guidage en translation selon un premier exemple de réalisation, l'élément mobile étant sollicité dans la direction hors-plan,
- la figure 15B représente le dispositif de la figure 15A, l'élément mobile étant sollicité en basculement,
- la figure 15C est une représentation schématique de l'orientation des différents éléments des moyens de guidage dans la situation la figure 15A,
- la figure 15D est une représentation schématique de l'orientation des différents éléments des moyens de guidage dans la situation la figure 15B,
- la figure 16 est une représentation d'un dispositif mettant en œuvre des moyens de guidage en translation selon un deuxième exemple de réalisation,
- la figure 17 est une représentation d'un dispositif mettant en œuvre des moyens de guidage en translation selon une variante du deuxième exemple de réalisation,
- la figure 18A une représentation d'un dispositif mettant en œuvre des moyens de guidage en translation selon un troisième exemple de réalisation,
- la figure 18B est une représentation d'une variante du dispositif de la figure 18A,
- la figure 19A est une représentation d'un dispositif mettant en œuvre des moyens de guidage en translation selon un quatrième exemple de réalisation,
- la figure 19B est une représentation d'une variante du dispositif de la figure 19A,
- la figure 19C est une représentation du dispositif de la figure 19B comportant des moyens de butée hors-plan,
- les figures 20 est une représentation d'un dispositif mettant en œuvre des moyens de guidage en translation selon un autre exemple de réalisation,
- la figure 21A est une vue de dessus d'un dispositif mettant en œuvre des moyens de guidage en translation selon le premier exemple de réalisation et comportant en outre des moyens de butée hors-plan,
- la figure 21B est une vue de côté du dispositif de la figure 21A,
- la figure 21C représente, vue de côté, le dispositif des figures 21A et 21B, dans un état de butée.

### EXPOSÉ DÉTAILLÉ DE MODES DE RÉALISATION PARTICULIERS

Dans la description qui va suivre, le dispositif MEMS et/ou NEMS sera désigné par « le dispositif ».

Dans les exemples représentés, le dispositif comporte une partie fixe et une partie mobile, mais ceci n'est pas limitatif. Le dispositif selon l'invention pourrait comporter deux parties mobiles l'une par rapport à l'autre au moins dans une direction hors-plan, les deux parties mobiles étant suspendues à une partie fixe.

En outre, la disposition relative de la partie mobile et de la partie fixe sur les figures n'est en aucun cas limitative et la disposition inverse peut être envisagée, par exemple en disposant le support au-dessus des électrodes fixes.

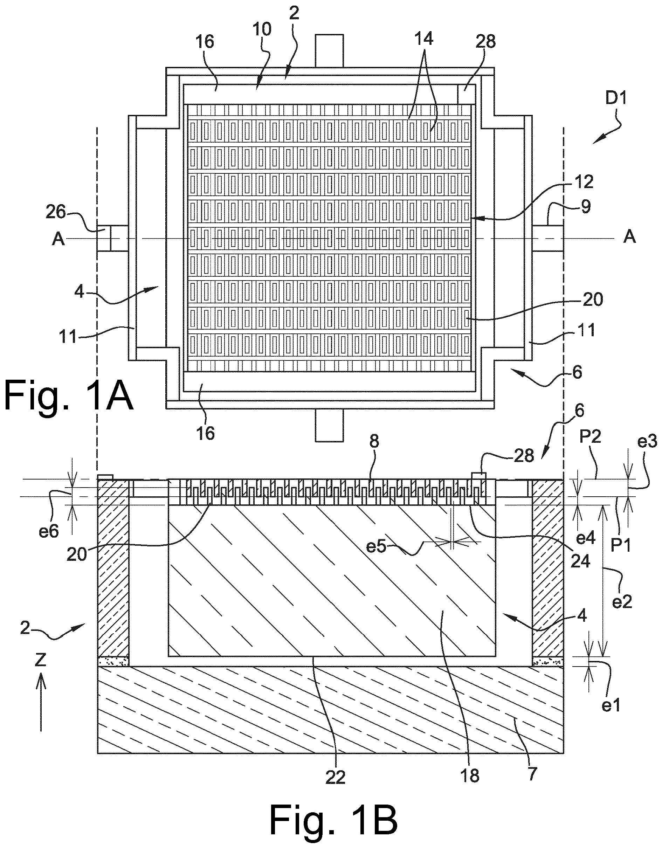

Sur les figures 1A et 1B, on peut voir un exemple de réalisation d'un dispositif D1 selon l'invention. Le dispositif D1 comporte un partie fixe 2 et une partie mobile 4 suspendue par rapport à la partie fixe 2 par des moyens de suspension 6, par exemple des ressorts, permettant à la partie mobile 4 de se déplacer dans une direction hors-plan Z orthogonale au plan moyen du dispositif.

La partie fixe 2 comporte un support ou substrat 7 et des électrodes fixes 8. Dans l'exemple représenté la partie fixe 2 comporte une portion fixe 10 suspendue au substrat. La portion fixe a une forme de grille comportant un cadre 12 et des barreaux 14 s'étendant entre un premier plan P1 orthogonal à l'axe Z et un deuxième plan P2 orthogonal à l'axe Z. Les barreaux formant les électrodes fixes 8 s'étendant le long de la direction Z entre les plans P1 et P2.

La partie suspendue fixe 10 est suspendue par ses bords latéraux 16.

La partie mobile 4 comporte un support mobile et des électrodes mobiles 20. Dans l'exemple représenté, le support mobile forme une masse 18. En outre, dans l'exemple représenté, la masse 18 a la forme d'un parallélépipède rectangle comportant une première face 22 et une deuxième face 24 perpendiculaires à la direction Z, la première face 22 étant en regard du substrat 7. La deuxième face 24 est disposée en regard de la portion suspendue fixe 10.

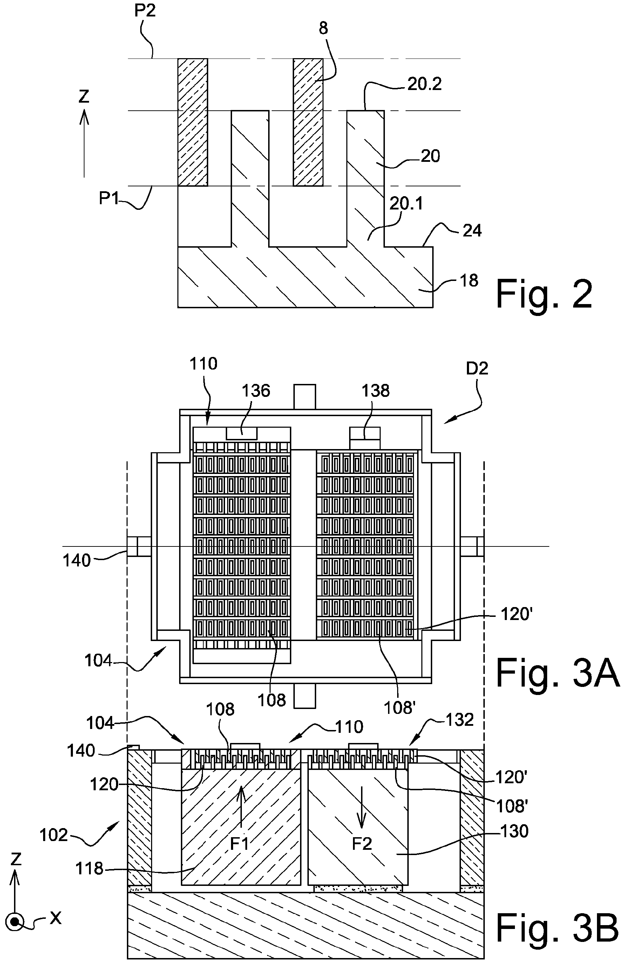

Sur la figure 2, on peut voir les électrodes mobiles 20 qui s'étendent longitudinalement le long de la direction Z et qui comportent une première extrémité 20.1 fixées directement à la deuxième face 24 de la masse 18 et une deuxième extrémité libre 20.2. Les électrodes mobiles 20 sont disposées entre les électrodes fixes 8, leur deuxième extrémité libre 20.2 étant située entre les plans P1 et P2.

Dans la présente demande, on entend par « une électrode s'étend le long de la direction Z » une électrode dont la ou les surfaces, destinées à être en regard de surfaces d'autres électrodes de sorte à former un ou des condensateurs à capacité variable à variation de surface, s'étendent sensiblement parallèlement à la direction Z. Par exemple, les électrodes peuvent être fines et allongées et présenter des surfaces importantes, l'entrefer entre les électrodes étant relativement petit du fait du ratio de gravure entre la profondeur de gravure et la largeur de gravure. En variante, les électrodes peuvent avoir une section transversale importante offrant une certaine rigidité, en conservant un entrefer relativement faible. Le ratio de gravure entre la profondeur de gravure et la largeur de gravure est par exemple de l'ordre de 20.

Dans l'exemple représenté, la masse 18 est située sous les électrodes fixes. Du fait de la connexion des électrodes mobiles directement à la deuxième face 20.1 de la masse 18, au repos au moins une partie seulement des électrodes mobiles est disposée entre les électrodes fixes. Ainsi au repos au moins la surface de chaque électrode mobile 20 en regard d'une électrode fixe 8 est inférieure à la surface totale de cette même électrode mobile et est inférieure à la surface totale de cette même électrode fixe en regard. Par exemple, au repos les électrodes ont de l'ordre de 50% de leur surface en regard d'une surface d'une autre électrode. Les électrodes ont typiquement une largeur de quelques centaines de nm à quelques µms et une hauteur de quelques µm.

Il en résulte que le déplacement dans la partie mobile le long de la direction Z dans un sens ou dans l'autre est détectable par toutes les électrodes fixes et mobiles.

Les moyens de suspension 6 s'étendent latéralement de la partie mobile vers la partie fixe. Dans l'exemple représenté ils sont situés au niveau des électrodes mobiles et sont ancrés au support par des plots d'ancrage 9. Dans l'exemple représenté, les moyens de suspension 6 sont au nombre de huit, ils sont formés chacun par une poutre 11 s'étendant parallèlement à un bord de la partie mobile et ancrée sur le plot 9. Les poutres 11 sont aptes à se déformer en flexion selon une direction hors-plan.

Dans l'exemple représenté, les électrodes mobiles ont la forme de doigts à section rectangulaire. Comme nous le verrons dans la suite de la description cette forme n'est pas limitative.

Le dispositif comporte également au moins un contact électrique 26 pour relier les électrodes mobiles à un système extérieur. Dans l'exemple représenté et de manière avantageuse, celui-ci est réalisé sur la partie fixe et est relié électriquement aux électrodes mobiles 20 par les moyens de suspension en matériau conducteur électrique. La connexion au système extérieur est facilitée. En variante le contact électrique 26 pourrait être réalisé directement sur la partie mobile.

Le dispositif comporte également un plot de contact 28 reliant des électrodes fixes 8 au système extérieur. Dans l'exemple représenté le contact est formé dans un coin du cadre.

A titre d'exemple uniquement, nous allons donner des dimensions du dispositif. Ces dimensions sont données au repos. Ces dimensions sont choisies en fonction de l'application du dispositif, de l'amplitude de déplacement de la partie mobile par rapport à la partie fixe souhaitée...

La distance e1 entre la première face 22 de la masse et le substrat est égale à 2 µm, l'épaisseur de la masse e2 est égale à 60 µm, l'épaisseur e3 du cadre qui correspond à la longueur des électrodes fixes est égale à 5 µm, la distance e4 entre la deuxième face 24 de la masse et la face en regard de la portion suspendue fixe contenue dans le plan P1 est égale à 3 µm et l'entrefer e5 entre une électrode fixe et une électrode mobile est égale à 400 nm. La longueur e6 des électrodes mobiles est également égale à 5 µm.

Sur la figure 2, on peut voir une vue agrandie du dispositif de la figure 1A au niveau des électrodes.

Le fonctionnement du dispositif va maintenant être décrit.

Dans le cas d'un dispositif de détection tel qu'un accéléromètre, lorsqu'une force d'accélération selon la direction Z s'applique à la masse, celle-ci est déplacée selon la direction Z. Lorsque la masse se déplace vers le haut dans la représentation de la figure 2, le rapport entre la surface des électrodes mobiles et la surface des électrodes fixes augmente et la capacité augmente et lorsque la masse se déplace vers le bas dans la représentation de la figure 2, le rapport entre la surface des électrodes mobiles et la surface des électrodes fixes diminue et la capacité diminue. Ainsi en détectant le sens de de variation de capacité il est possible de déterminer le sens déplacement de la partie mobile.

Toutes les électrodes participent à la détection du sens de déplacement de la partie mobile.

En outre toute la surface de la masse est munie d'électrodes, le dispositif présente donc une grande densité d'électrodes.

Dans le cas d'un actionneur, du fait du décalage selon la direction des électrodes fixes et mobiles, l'application d'une différence de potentiel entre les électrodes provoque une attraction entre les électrodes, la partie mobile se rapprochant alors de la portion suspendue fixe 10, la partie mobile 4 est donc déplacée vers le haut dans la représentation de la figure 1B.

Sur les figures 3A et 3B, on peut voir un autre exemple de réalisation d'un dispositif D2 selon l'invention. Ce dispositif diffère de celui des figures 1A et 1B en ce qu'une partie des électrodes mobiles n'est pas directement fixée à la deuxième face de la masse.

Le dispositif comporte une partie fixe 102 comprenant une portion suspendue fixe 110 comportant des électrodes fixes 108 et une portion ancrée 130 ancrée directement sur le substrat.

La portion suspendue fixe 110 est similaire à la portion suspendue fixe 10 du dispositif des figures 1A et 1B.

La portion ancrée 130 a, dans l'exemple représenté, la forme d'un parallélépipède rectangle comportant une face libre perpendiculaire à la direction Z comportant des électrodes fixe 108' s'étendant le long de la direction Z.

Dans l'exemple représenté, la partie suspendue fixe 110 et la portion ancrée 130 ne sont pas connectées mécaniquement directement afin d'éviter les connexions électrique. En variante, elles pourraient être connectées mécaniquement directement mais isolées électriquement l'une de l'autre.

La partie suspendue fixe 110 et la portion ancrée 130 sont isolées électriquement l'une de l'autre. Le dispositif D2 comporte un plot de connexion électrique 136 pour relier les électrodes 108 au système extérieur et un plot de connexion électrique 138 pour relier les électrodes 108' au système extérieur.

La partie mobile comporte une masse 118, des électrodes mobiles 120 sur sa deuxième face s'étendant le long de la direction Z. La partie mobile comporte également une portion suspendue mobile 132 s'étendant entre la masse 118 et la partie fixe 102. La portion suspendue mobile 132 comporte une structure en forme de grille dont les barreaux forme des électrodes mobiles 120'. La portion suspendue mobile 132 est reliée rigidement à la masse 118 de sorte à former une partie mobile unique et est suspendue à la partie fixe par des moyens de suspension.

La partie suspendue mobile 132 est disposée au-dessus de la portion ancrée 130 de sorte que les électrodes fixes 108' soient disposées entre les électrodes mobiles 120'.

Comme cela est schématisé sur la figure 3A, la partie mobile s'étend donc pour partie en-dessous la partie fixe et pour partie au-dessus de la partie fixe.

Le dispositif comporte donc un premier ensemble capacitif comportant la masse 118 et la portion suspendue fixe 110 et un deuxième ensemble capacitif comportant la portion suspendue mobile 132 et la portion ancrée 130.

Les moyens de suspension de la partie mobile sont similaires à ceux du dispositif D1.

Un plot de connexion électrique 140 de la partie mobile est prévu sur la partie fixe et est relié électriquement à la partie mobile par les moyens de suspension.

Le fonctionnement du dispositif D2 en détection est le suivant :
Lorsqu'une accélération s'exerce sur la masse, celle-ci se déplace le long de la direction Z, provoquant le déplacement des électrodes 120 par rapport aux électrodes 108 et des électrodes 120' par rapport aux électrodes 108'. Par exemple, lorsque la masse se déplace vers le haut, les électrodes 120 pénètrent davantage entre les électrodes 108 et les électrodes 120' s'éloignent des électrodes 108'. Les capacités des premier et deuxième ensembles capacitifs varient en sens inverse.

Du fait de la répartition en deux groupes des électrodes mobiles et fixes et de la polarisation séparée des électrodes fixes, cette structure permet une détection différentielle. En outre les forces électrostatiques générées par la polarisation des électrodes entre les électrodes 108 et 120 et entre les électrodes 108' et 120' s'équilibrent. Le décalage du à cette polarisation est donc supprimé.

Dans le cas d'un actionneur, les électrodes sont polarisées. Les électrodes 120 pénètrent entre les électrodes 108, la masse se déplace vers le haut selon la flèche F1 et les électrodes 120' pénètrent entre les électrodes 108' vers le bas selon la flèche F2. Les flèches F1 et F2 ont des sens opposés, il en résulte que la partie mobile pivote autour d'un axe X. Le dispositif D2 permet donc de réaliser un actionneur générant un couple de rotation autour de l'axe X. On peut envisager de n'appliquer la différence de potentiel que sur l'une des deux électrodes pour réaliser une translation.

Les dimensions du dispositif D2 peuvent être identiques à celles du dispositif D1.

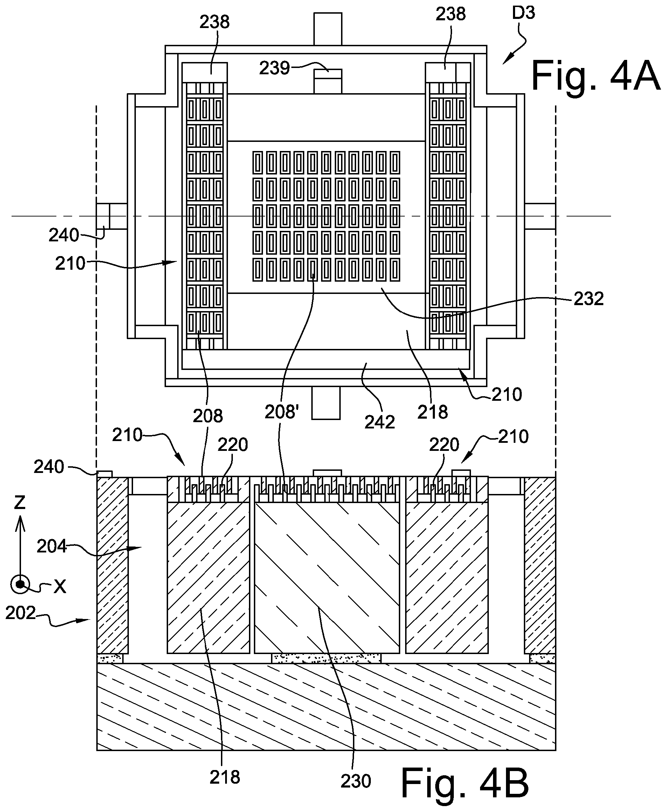

Sur les figures 4A et 4B, on peut voir une variante D3 du dispositif D2.

D3 comporte une partie fixe 202 comprenant une portion ancrée 230 et deux portions suspendues fixes 210 situées de part et d'autre de la portion ancrée 230.

La portion ancrée 230 comporte des électrodes fixes sur sa face libre s'étendant le long de la direction Z. les deux portions suspendues fixes 210 sont similaires à la portion suspendue fixe 110. Elles sont reliées mécaniquement à une extrémité longitudinale par une poutre 242 qui assure également leur ancrage sur le substrat. Les portions suspendues fixes 210 sont ancrées au substrat également par leur autre extrémité longitudinale. La portion ancrée 230 est isolée électriquement des portions suspendues fixes 210. Comme pour le dispositif D2, les partie suspendue fixes 210 ne sont pas connectées mécaniquement directement à la portion ancrée 230 afin d'éviter les connexions électrique. En variante, elles pourraient être connectées mécaniquement directement et isolées électriquement l'une de l'autre.

Un plot de connexion électrique 238 permet la connexion électrique des électrodes 208 et un plot de connexion électrique 239 permet la connexion électrique séparée des électrodes 208'.

La partie mobile 204 comporte une portion suspendue mobile232 et une masse 218 entourant la portion suspendue mobile 232 et formant un ensemble rigide avec celle-ci. La portions suspendue mobile 232 est similaire à la portion suspendue mobile 132. Vue de dessus la masse 218 a la forme d'un cadre. Des électrodes mobiles 220 sont fixées sur la deuxième face de la masse 218 et s'étendent le long de la direction Z.

Les moyens de suspension de la partie mobile sont similaires à ceux du dispositif D1.

Un plot de connexion électrique 240 assure la connexion électrique de la partie mobile 204 au système extérieur.

Comme on peut le voir sur la figure 4B, la partie mobile 204 est disposée au niveau de sa zone centrale au-dessus de la partie fixe 202 et au niveau des zones latérales en-dessous de la partie fixe.

Les dimensions du dispositif D3 peuvent être identiques à celles des dispositifs D1 et D2.

Le dispositif D3 comporte donc un premier ensemble capacitif comportant la masse 218 et les portions suspendues fixes 210 et un deuxième ensemble capacitif comportant la portion suspendue mobile 232et la portion ancrée 230.

Le fonctionnement du dispositif D3 est similaire à celui du dispositif D2.

Comme dans le cas du dispositif D2, le dispositif D3 permet une détection différentielle. Il permet également d'équilibrer les forces électrostatiques dues la polarisation des électrodes de détection. Par rapport au dispositif D2, la partie mobile du dispositif D3 n'a pas de mouvement de rotation autour de l'axe X du fait de la répartition symétrique de forces électrostatiques vers le haut et vers le bas de part et d'autre du plan contenant les axes X et Z. Les détections erronées dues au basculement de la masse sont évitées.

Afin d'utiliser le dispositif de D3 en tant qu'actionneur, la portion ancrée et les portions suspendues fixes sont polarisées différemment.

En variante, la masse pourrait comporter des électrodes sur toute sa surface supérieure et les portions suspendues fixes pourraient recouvrir toute la masse.

En variante, le dispositif D3 pourrait comporter une partie fixe comprenant une portion suspendue fixe et deux portions ancrées de part et d'autre de la portions suspendue fixe et une partie mobile comportant une masse centrale entourée par une portion suspendue mobile en forme de cadre.

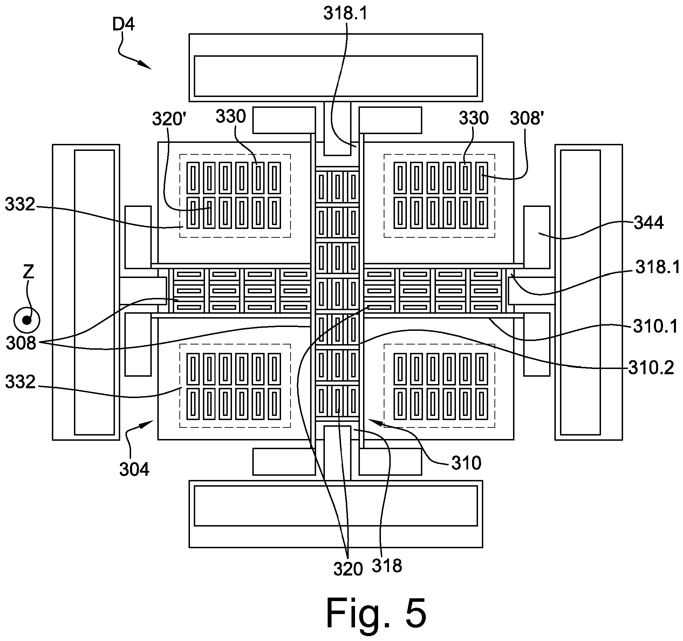

Sur la figure 5, on peut voir un autre exemple de réalisation d'un dispositif D4 selon l'invention. Le dispositif D4 a, vu de dessus, une forme rectangulaire.

D4 comporte une partie fixe comportant une portion suspendue fixe 310 comportant deux branches 310.1, 310.2 orthogonales et formant une croix. Les deux branches 310.1, 310.2 forment des grilles dont les barreaux forment des électrodes fixes 308 s'étendant le long de la direction Z et sont ancrées sur le support par leurs extrémités longitudinales par des plots d'ancrages 344. La partie fixe comporte quatre portions ancrées 330 comportant des électrodes fixes 308' sur la deuxième face et s'étendant le long de la direction Z. Vue de dessus, les quatre zones définies par la portion suspendue mobile sont occupées par une portion ancrée 330.

Les quatre portions ancrées 330 peuvent être polarisées chacune par un contact électrique (non représenté). En variante, les quatre portions ancrées 330 sont reliées électriquement entre elles et polarisées par un seul contact électrique. Ceci est rendu possible grâce à un procédé de réalisation mettant en œuvre deux couches comme cela sera décrit ci-dessus. Par ailleurs, la portion suspendue fixe 310 est isolée des portions ancrées 330 et est polarisée de manière indépendante des portions ancrées 330.

La partie mobile 304 a, vue de dessus, une forme de rectangle. Elle forme une masse comportant quatre trous rectangulaires recevant chacun une portion ancrée 330. Chaque trou est fermée par une portion suspendue mobile 332 disposée au-dessus d'une portion ancrée 330. Chaque portion suspendue mobile 332 a la forme d'une grille dont les barreaux forment des électrodes mobiles 320'. Des électrodes mobiles 320 sont formées sur la masse et disposées en croix de sorte à coopérer avec la partie suspendue fixe. Les bras de la croix forment les médiatrices du rectangle formé par la partie mobile. La masse comporte des électrodes mobiles 320.

Le dispositif comporte donc un premier ensemble capacitif comportant la partie mobile 304 et la portion suspendue fixe 310 et un deuxième ensemble capacitif comportant les portions suspendues mobiles 332 et les portions ancrée 330.

De manière avantageuse, la partie mobile est suspendue au support par quatre moyens de suspension reliés à la partie mobile au niveau des extrémités 318.1 des branches de la croix qui forment les zones les plus rigides de la partie mobile, évitant une mise en flexion de la partie mobile. Les moyens de suspension sont similaires à ceux des dispositifs décrits ci-dessus. En variante, la partie mobile pourrait être suspendue par les portions suspendues mobiles 332.

Ce dispositif D4 présente l'avantage de réduire la proportion de surface suspendue de faible épaisseur d'un seul tenant et donc de réduire les risques d'endommagement. En effet, par rapport au dispositif D3, la portion suspendue mobile est divisée en quatre zones de surface réduite tendues entre deux branches de la masse 318. En outre, comme le dispositif D3 la structure du dispositif D4 est équilibrée, la partie mobile ne subit pas de décalage résultant de la polarisation des électrodes en détection et ne subit pas de couple la faisant pivoter. Les détections erronées dues au basculement de la masse sont ainsi évitées.

Comme pour le dispositif D3, il est envisageable d'intervertir la partie mobile et la partie fixe.

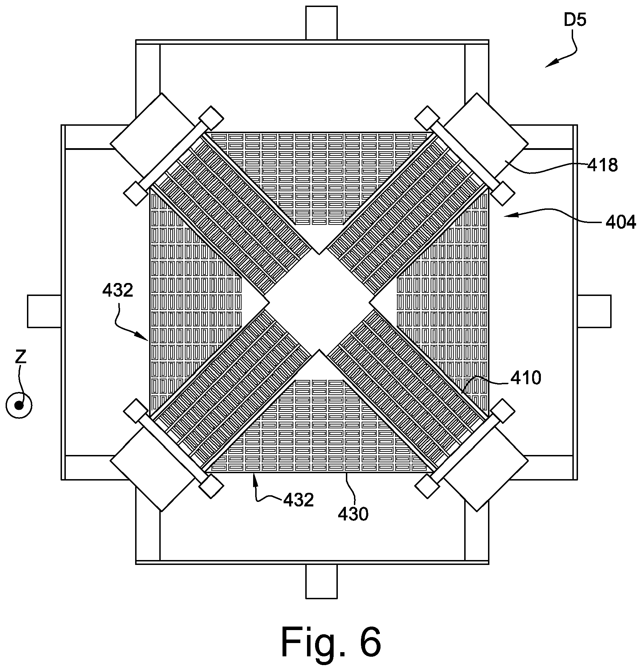

Sur la figure 6, on peut voir un dispositif D5 qui est une variante du dispositif D4. Le dispositif D5 diffère du dispositif D4 en ce que la masse 418 en forme de croix forme les diagonales du rectangle formé par la partie mobile 404. Les portions suspendues mobiles 432 ont alors la forme de triangle et sont suspendues à la masse par deux de leurs côté, avantageusement par leurs trois côtés si la masse mobile les entoure.

De manière avantageuse la partie mobile est suspendue par les extrémités de la masse 418.

La partie suspendue fixe 410 a également une forme de croix disposée au-dessus de la masse 418.

Les portions ancrées 430 ont des forme de triangle et sont situées sous les portions suspendues mobiles.

Les portions ancrées 430 sont isolées électriquement de la partie suspendue fixe 410 et sont polarisées séparément.

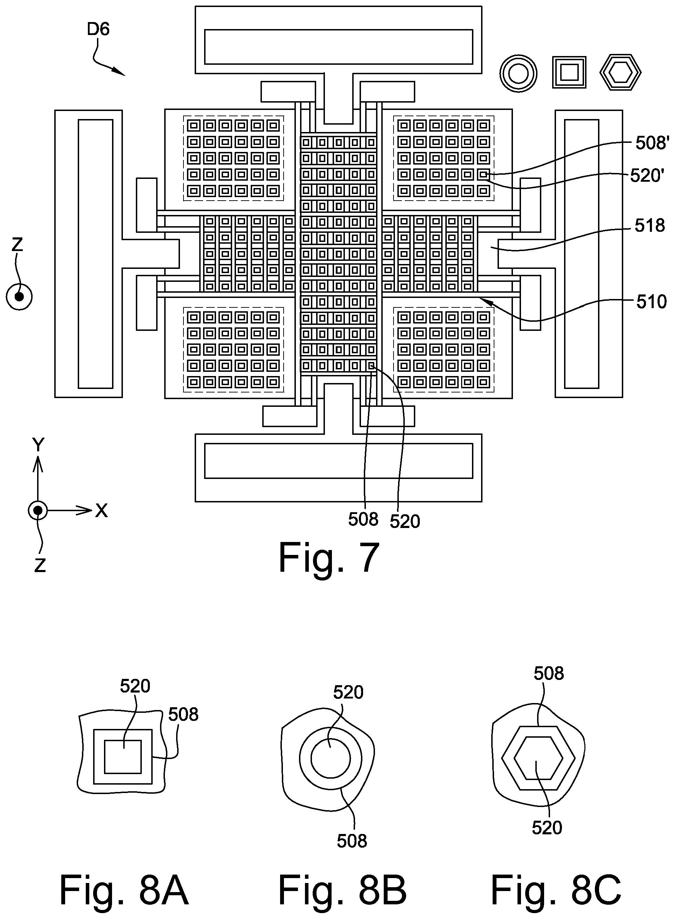

Sur la figure 7, on peut voir une variante D6 du dispositif D4.

Le dispositif D6 diffère du dispositif D4 par la forme des électrodes.

La masse 518 du dispositif D6 comporte des électrodes mobiles 520 dont la section par un plan parallèle au plan moyen du dispositif a une forme carrée. La partie suspendue fixe 510 comporte des électrodes fixes 508 délimitant entre elles des passages de section carrée. Les électrodes fixes 508' de la partie ancrée 530 sont de section carrée et sont reçues entre les électrodes 520' de la portion suspendue mobile 532. Toute la surface latérale des électrodes participe à la variation de capacité.

Cette forme d'électrode réduit la densité capacitive, mais elle présente l'avantage de réduire les risques d'adhésion dus au phénomène de pull-in car les forces électrostatiques se répartissent également entre les deux directions X et Y orthogonales dans le plan, au lieu de se concentrer sur une seule direction, par exemple dans le cas d'électrodes rectangulaires. De plus la structure est plus équilibrée, elle subit les mêmes forces, et les changements de comportement associés, dans les deux directions X et Y.

Sur la figure 8A, on peut voir agrandie une électrode mobile 520 reçue dans une électrode fixe 508. D'autres formes sont envisageables, par exemple des électrodes à section circulaire ou à section polygonale telle qu'une section hexagonale, comme cela est représenté sur les figures 8A, 8B et 8C.

Les autres éléments du dispositif sont similaires à ceux de D4.

Dans tous les exemples de réalisation, il pourrait être envisagé d'avoir une partie mobile avec plusieurs polarisations, les électrodes de la masse étant isolées des électrodes de la partie suspendue mobile. Pour cela, la masse mobile et le cadre mobile pourraient être reliés par une couche d'oxyde partiellement libérée. Avantageusement, les parties fixes peuvent être potentiellement connectées électriquement.

Tous les dispositifs D1 à D6 peuvent être utilisés comme dispositifs de détection ou comme actionneur, ils sont néanmoins plus adaptés à la réalisation de dispositifs de détection du fait de la présence d'une masse inertielle qui intervient dans la détection de force inertielle. En général les actionneurs ne requièrent pas dans leur fonctionnement la mise en œuvre de masse.

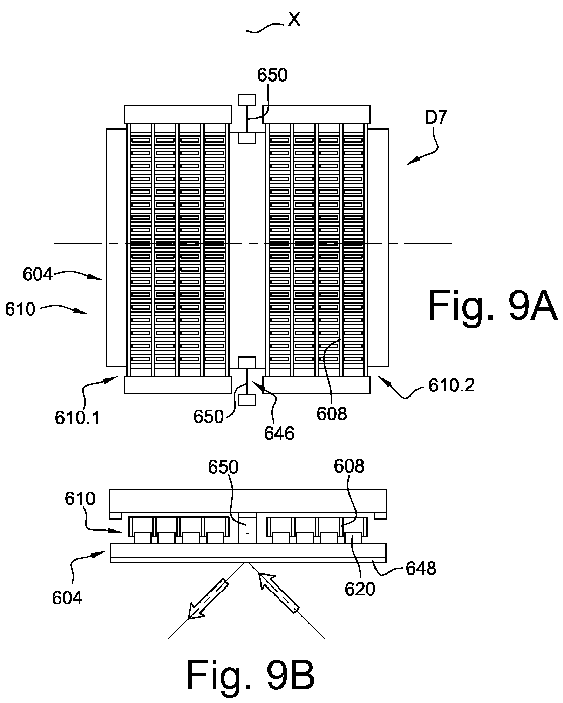

Sur les figures 9A et 9B, on peut voir un exemple d'un dispositif D7 selon l'invention particulièrement adapté à être utilisé comme actionneur. Dans cet exemple, l'actionneur est utilisé pour déplacer un micro-miroir. Mais le dispositif selon l'invention peut être utilisé par exemple également pour réaliser un gyromètre avec un actionnement hors-plan, des résonateurs MEMS...

Le dispositif D7 comporte un substrat, une partie suspendue fixe 610, une partie mobile 604 par une articulation pivot 646. Dans l'exemple représenté, l'articulation pivot 646 comporte deux poutres 650 alignées selon l'axe X de l'articulation pivot et aptes à se déformer en torsion autour de l'axe du pivot.

La partie suspendue fixe 610 comporte deux sous-ensembles 610.1, 610.2 d'électrodes fixes 608, disposés de part et d'autre de l'axe pivot X électriquement isolés l'une de de l'autre de sorte à pouvoir les polariser séparément et différemment.

La partie suspendue mobile comporte sur une face les électrodes mobiles 620 et sur l'autre face une surface réfléchissante 648 formant le miroir. Suivant l'état de polarisation des électrodes fixes, le miroir pivote dans un sens ou dans l'autre autour de l'axe X.

Comme on peut le voir sur, les figures 9A et 9B, l'actionneur ne met pas en œuvre de partie mobile épaisse formant masse sismique, mais un actionneur avec une masse sismique entre dans le cadre de la présente invention.

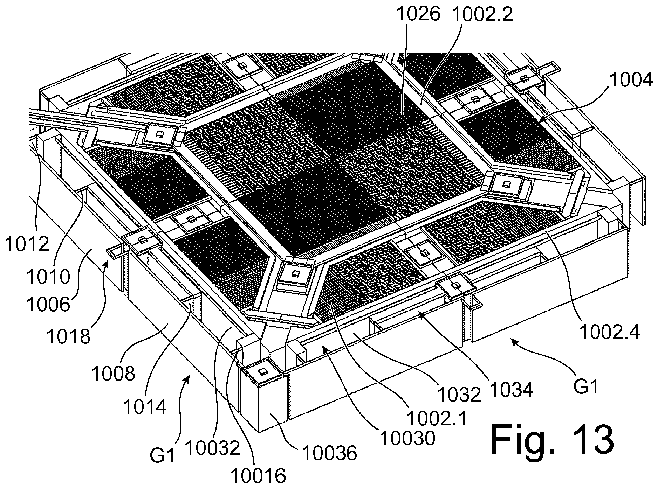

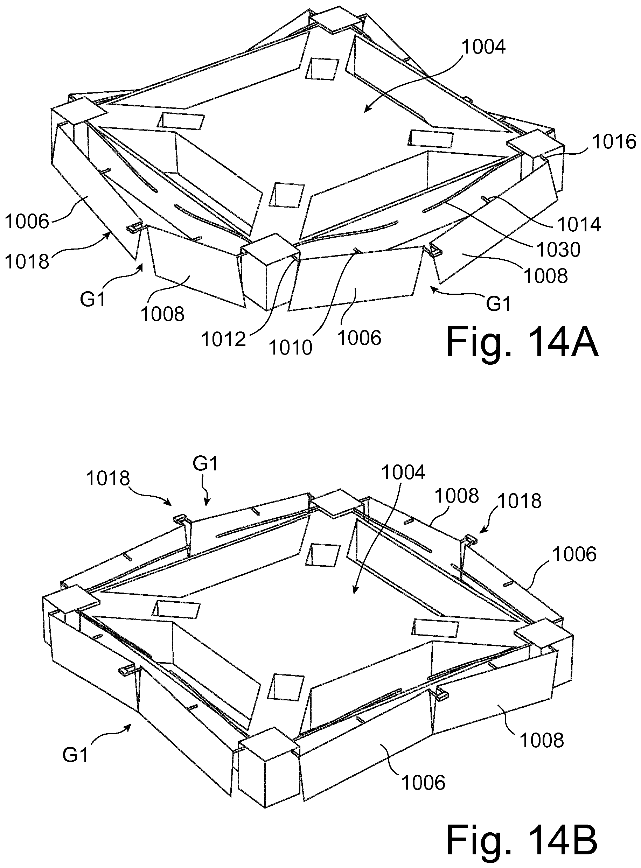

Sur les figures 13 et 14A et 14B, on peut voir représenté partiellement un exemple de réalisation d'un dispositif selon l'invention particulièrement avantageux, comportant des moyens de guidage du déplacement hors plan de la partie mobile. Ce dispositif peut être utilisé comme accéléromètre hors-plan.

Ce dispositif permet de réaliser une mesure différentielle du déplacement de la masse.

Le dispositif comporte deux ensembles de détection de sorte à permette la mesure différentielle.

Le dispositif comporte une masse 1004 comprenant un cadre extérieur 1024 situé au-dessus d'une première partie 1002.1 du support et une partie centrale 1026 située au-dessous d'une deuxième partie 1002.2 du support.

Le cadre et la première partie 1002.1 comportent des électrodes interdigitées formant des premiers condensateurs et la partie centrale 1026 et la deuxième partie 1002.2 comportent des électrodes interdigitées formant des deuxièmes condensateurs. Le déplacement hors-plan de la masse provoque une variation opposée des capacités des premiers et deuxièmes condensateurs, ce qui permet la mesure différentielle.

Le dispositif comporte également les moyens de suspension 1030 de la masse par rapport au support 1002.

Dans cet exemple, les moyens de suspension 1030 sont au nombre de huit, deux par côté de la masse. Ils sont formés chacun par une poutre 1032 s'étendant parallèlement à un bord dudit élément mobile et ancrée par une extrémité à un plot d'ancrage 1034 du support et par une autre extrémité à la masse. Les poutres 1032 sont aptes à se déformer en flexion selon une direction hors-plan. Les poutres 1032 sont également déformables en flexion dans le plan, mais le fait de mettre en œuvre 1008 poutres 1032 est équivalent à opposer au déplacement dans le plan la raideur en compression/étirement importante d'une poutre orthogonale. Ces moyens de suspension assurent donc une certaine rigidité dans le plan.

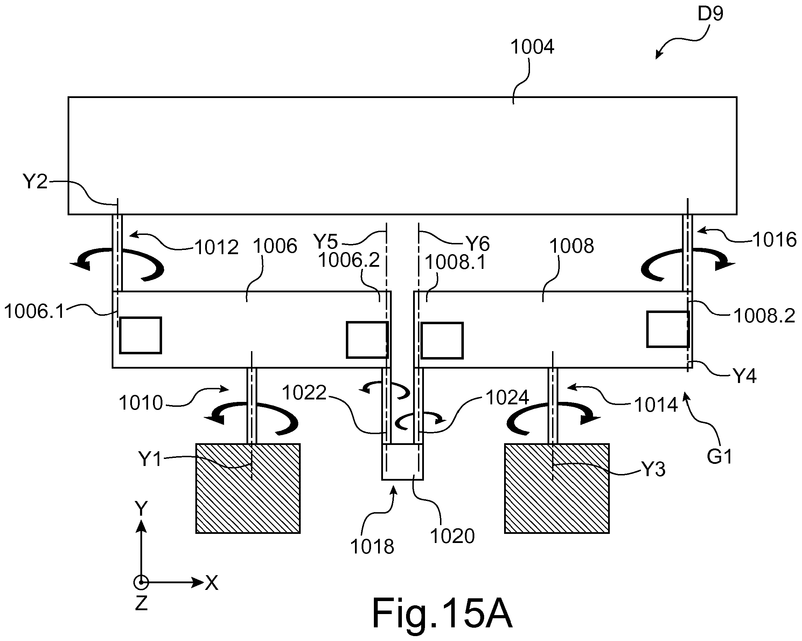

Le dispositif comporte également des moyens de guidage G1. Chacun des moyens de guidage s'étend le long d'un côté du cadre 1026. Les moyens de guidage sont représentés de manière schématique sur les figures 15A à 15D.

Sur les figures 15A à 15D, on peut voir une représentation schématique des moyens de guidage G1 selon un premier exemple de réalisation.

Le dispositif D9 s'étend principalement dans le plan XY. Le dispositif D9 comporte un support 1002, un élément destiné à se déplacer le long de la direction Z orthogonal au plan XY. L'élément 1004 est suspendu par rapport au support de sorte à pouvoir se déplacer par rapport au support. Dans cette représentation schématique, le support 1002 est schématisé par deux plots d'ancrage.

L'élément mobile 1004 est considéré comme rigide.

Un élément est désigné comme rigide dans la présente demande, lorsque ses déformations sont négligeables par rapports au déplacement global dans la direction hors-plan.

Le dispositif D9 comporte également de moyens de guidage G1 en translation de l'élément 1004 le long de la direction Z.

Les moyens G1 comportent deux bras rigides 1006, 1008. Dans cet exemple, les deux bras sont alignés le long de la direction X. Chaque bras 1006, 1008 comporte deux extrémités longitudinales 1006.1, 1006.2 et 1008.1, 1008.2 respectivement. Les extrémités 1006.2 et 1008.1 sont disposées à proximité et sont désignées « extrémités proximales », et les extrémités 1006.1 et 1008.2 sont désignées « extrémités distales ». Dans cet exemple, les faces des extrémités proximales 1006.2 et 1008.1 sont en regard.

Le bras 1006 est relié mécaniquement au support par une première liaison pivot 1010 d'axe Y1 et est relié mécaniquement à l'élément par une deuxième liaison pivot 1012 d'axe Y2.

Le bras 1008 est relié mécaniquement au support par une troisième liaison pivot 1014 d'axe Y3 et est reliée mécaniquement à l'élément par une quatrième liaison pivot 1016 d'axe Y4.

Dans l'exemple représenté, la première liaison pivot 1010 se situe au centre du bras 1006 et la deuxième articulation pivot 1012 se situe au niveau de l'extrémité distale 1006.1. La troisième articulation pivot 1014 se situe au centre du bras 1008 et la quatrième liaison pivot 1016 se situe au niveau de l'extrémité distale 1008.2.

En outre les moyens G1 comportent une articulation 1018 entre les deux bras 1006, 1008, reliant les extrémités proximales 1006.2 et 1008.1.

L'articulation 1018 comporte une pièce rigide 1020 et deux liaisons pivots 1022, 1024 d'axe Y5, Y6, chaque liaison pivot 1022, 1024 reliant la pièce rigide 1020 à une extrémité proximale 1006.2, 1008.1 respectivement.

Les axes des articulations pivots 1010, 1012, 1014, 1016, 1022, 1024 sont parallèles entre eux.

Au moins deux articulations pivots reliées à chaque bras présente un degré de liberté en translation dans le plan du dispositif le long des bras. Les articulations pivots comportent avantageusement une poutre apte à se déformer en torsion autour de l'axe de pivot. Les poutres offrent une certaine aptitude à la flexion

Dans l'exemple représenté, toutes les liaisons pivots 1010, 1012, 1014, 1016, 1020, 1022 sont réalisées par des poutres aptes à se déformer en torsion autour de l'axe de pivot.

Ce degré de liberté en translation peut être conféré à toutes les articulations pivots. Dans l'exemple représenté et de manière avantageuse, les liaisons pivots sont réalisées par des poutres aptes à se déformer en torsion autour de l'axe de pivot.

Les bras 1006 et 1008 se déplacent dans un plan P1 parallèle au plan XZ.

Le fonctionnement de l'invention va maintenant être décrit dans le cas d'un accéléromètre, l'élément 1004 formant par exemple une masse inertielle.

Lorsque le capteur est soumis à une accélération hors-plan, i.e. le long de la direction Z, la masse inertielle 1002 est déplacée en translation le long de la direction Z. Les moyens de guidage G1 accompagnent la masse inertielle. Les bras 1006, 1008 pivotent autour des liaisons 1012, 1016 dans des sens opposés, comme cela est schématisé sur la figure 15A. Les liaisons pivots 1010 et 1014 sont également sollicitées dans des directions opposées, ainsi que les liaisons 1022, 1024. L'articulation 1018 impose un même déplacement hors plan aux extrémités distales 1006.1, 1008.2, et donc, impose aux bras de pivoter dans des sens opposés.

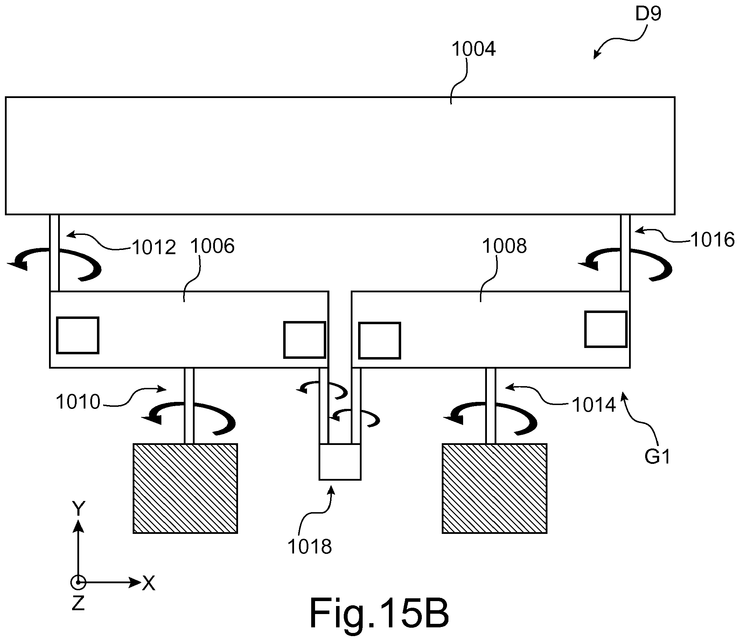

Par ailleurs, puisque les bras et leurs liaisons pivots sont symétriques l'un de l'autre, les extrémités distales se déplacent de la même distance, imposant à la masse un déplacement parallèle au support (figure 15B)

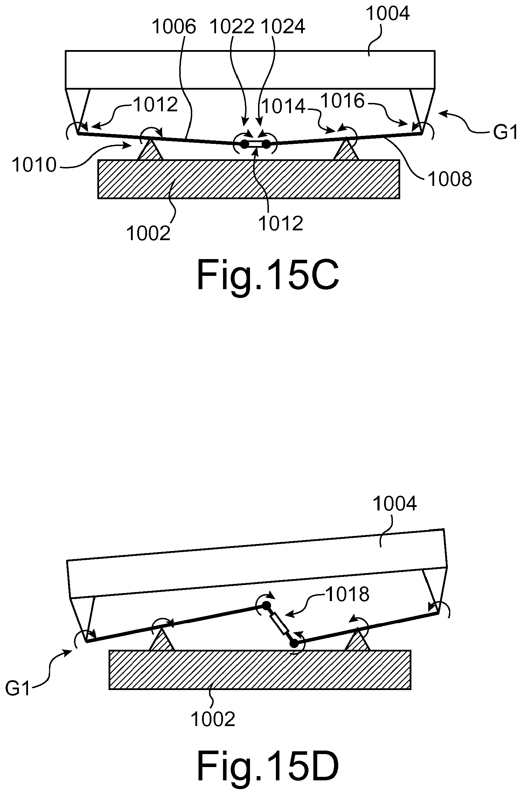

Dans le cas d'une accélération dans le plan, les sens de rotation au niveau de toutes les liaisons pivots sont les mêmes comme cela est représenté sur la figure 15C, ce qui tend à écarter les extrémités proximales 1006.2 et 1008.1 et à faire basculer la masse inertielle autour d'un axe parallèle à Y

La mise en œuvre de l'articulation 1018 entre les bras, et plus généralement des moyens de guidage G1, augmente la rigidité et réduit, voire empêche, un tel basculement de la masse inertielle, ce qui limite les risques d'une non-linéarité dans la mesure du déplacement de la masse et les risques d'endommagement par contact. L'effet de l'articulation 1018 est représenté schématiquement sur la figure 15D. Dans cette représentation, le basculement de la masse est exagéré à des fins d'illustration, mais il sera compris que grâce à l'invention, un basculement d'une telle amplitude n'est pas autorisé

De préférence, le dispositif MEMS et/ou NEMS comporte plusieurs moyens de guidage G1 comme c'est le cas dans le dispositif de la figure 13, et au moins deux moyens de guidage dont les bras se déplacent dans des plans P1, P2 orthogonaux réduisant encore davantage les déplacements dans le plan. De manière avantageuse, il comporte trois moyens de guidage, les bras de deux moyens de guidage se déplaçant dans des plans parallèles et les bras des autres moyens de guidage se déplaçant dans un plan orthogonal. Ainsi la rigidité dans le plan offert par les moyens de guidage est sensiblement améliorée.

Les bras 1006 et 1008 peuvent être de dimensions différentes et/ou les liaisons pivots pourraient ne pas être disposées de manière symétrique. Mais les choix des dimensions et de l'emplacement des liaisons pivots sont faits de sorte que l'élément mobile a effectivement un déplacement hors plan.

Dans des exemples de réalisation, le dispositif peut comporter des moyens de suspension spécifiques de l'élément, en effet les moyens de guidage selon l'invention peuvent ne pas pouvoir assurer la suspension et/ou assurer un maintien dans le plan suffisamment rigide. En effet, les poutres de torsion présentent également une certaine aptitude à la flexion pouvant ne pas offrir un maintien suffisant de l'élément mobile dans le plan.

Sur la figure 13, les extrémités distales 1006.1, 1008.2 des bras 1006, 1008 de chacun des moyens de guidage sont mécaniquement reliées par une liaison pivot aux extrémités longitudinales des bords du cadre de la masse. Dans l'exemple représenté, le support comporte quatre plots d'ancrage 1036 situés en regard des quatre sommets de la masse et destinés à coopérer avec les bras 1006, 1008 pour former des butées comme cela sera décrit plus en détail par la suite.

Dans cet exemple pratique, les bras 1006, 1008 sont formés par des lames présentant une grande largeur dans la direction Z et offrant donc une grande rigidité dans cette direction.

En outre dans l'exemple représenté, les liaisons pivots et l'articulation 1018 se situent dans une partie supérieure des bras 1006, 1008. Il sera compris que les liaisons pivots et l'articulation 1018 peuvent se situées dans des zones intermédiaires et/ou dans une partie inférieure des bras et/ou dans la partie supérieure.

Les moyens de guidage assurent donc le guidage de la masse au niveau de ses quatre sommets.

Les moyens de suspension 1030 limitent, voir évitent les mouvements dans le plan. La combinaison des moyens de suspension et des moyens de guidage permet de réaliser un dispositif dont la maîtrise du comportement de la masse est améliorée.

Sur les figures 14A et 14B, on peut voir le dispositif de la figure 13 dans deux états différents. Sur la figure 14A, la masse est en position basse et sur la figure 14B, la masse est en position haute.

Dans l'exemple de la figure 13, l'élément mobile est de forme carrée et comporte quatre moyens de guidage.

On peut envisager que l'élément mobile soit par exemple triangulaire et comporte trois moyens de guidage. Dans ce cas, les plans des différents moyens de guidage sont sécants sans être orthogonaux.

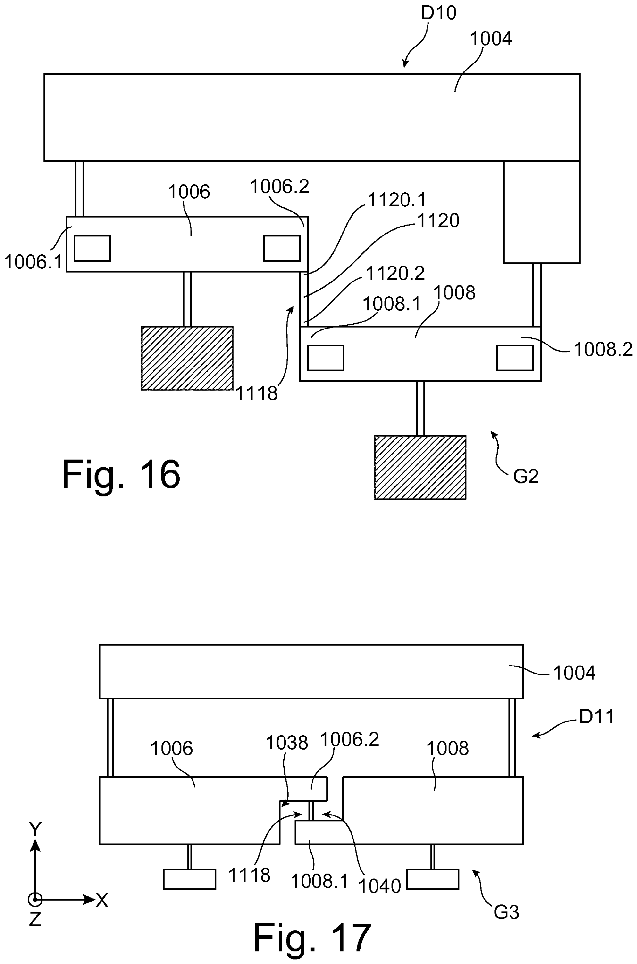

Sur les figures 16 et 17, on peut voir un deuxième exemple de réalisation d'un dispositif selon l'invention.

Le dispositif D10 diffère du dispositif D9 notamment en ce que les moyens de guidages G2 diffèrent des moyens de guidage G1 par l'articulation 1118 entre les bras 1006, 1008.

Sur la figure 16, les bras 1006 et 1008 sont disposés dans deux plans parallèles. Ainsi les faces des extrémités proximales 1006.2, 1008.1 ne sont plus en regard mais sensiblement dans un même plan R perpendiculaire au plan des bras 1006, 1008.

L'articulation 1118 comporte une poutre de torsion 1120 s'étendant dans le plan R, dont une extrémité longitudinale 1120.1 est reliée mécaniquement à un flan de la poutre 1006 et une autre extrémité 1120.2 est reliée mécaniquement à un flan de la poutre 1008 en regard. La mise en œuvre d'une poutre de torsion offre une rigidité augmentée.

Sur la figure 17, on peut voir une variante de dispositif D11 avantageuse du dispositif D10. Dans le dispositif D11, les poutres 1006, 1008 des moyens de guidage G3 sont telles qu'elles offrent un encombrement réduit par rapport à la structure de D10. Pour cela les extrémités proximales 1006.2, 1008.1 des poutres comportent une découpe 1038, 1040 respectivement permettant aux poutres d'être rapprochées.

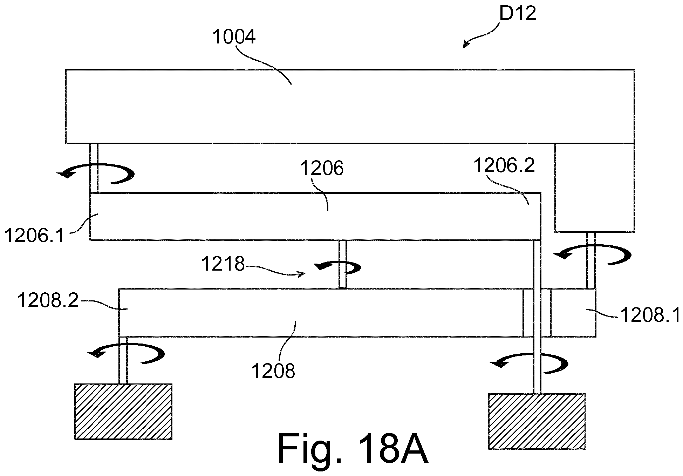

Sur la figure 18A, on peut voir un autre exemple de réalisation d'un dispositif D12 selon l'invention.

Dans le dispositif D12, les dispositions des liaisons pivots sont modifiées par rapport à celles des dispositifs D9 à D11.

Dans le dispositif D12, les moyens de guidage G4 comportent deux bras 1206, 1208 disposés dans deux plans parallèles et une articulation 1218 entre les bras 1206, 1208.

Une face latérale du bras 206 est en regard d'une face latérale du bras 1208 et l'articulation 1218 s'étend entre les deux faces latérales.

De manière avantageuse, l'articulation est formée par une poutre déformable en torsion.

La liaison pivot entre la poutre 1206 et l'élément mobile est située au niveau d'une extrémité longitudinale 1206.1 de la poutre 1206, et la liaison pivot entre la poutre 1206 et le support est située au niveau de l'autre extrémité longitudinale 1206.2 de la poutre 1206.

La liaison pivot entre la poutre 1208 et l'élément mobile est située au niveau d'une extrémité longitudinale 1208.1 de la poutre 1208 et la liaison pivot entre la poutre 1208 et le support est située au niveau de l'autre extrémité longitudinale 1208.2 de la poutre 1208.

Les liaisons pivots sont avantageusement réalisées par des poutres déformables en torsion.

Dans l'exemple représenté, la liaison pivot entre l'extrémité 1206.2 de la poutre 1206 et le support croise la poutre 1208, elle est située dans un plan disposé entre le support et la poutre 1208 afin de ne pas gêner le déplacement de la poutre 1208.

Dans cet exemple de réalisation, les bras présentent une longueur augmentée par rapport aux bras des dispositifs D9 à D11. Il en résulte que pour un même déplacement hors-plan de l'élément mobile, le déplacement angulaire des bras est réduit. D'un côté, il est alors possible de mettre en œuvre au moins une articulation 1218 plus rigide, rendant le dispositif plus rigide. D'un autre côté, la raideur du barre de torsion face à un mouvement souhaité est réduite et permet d'obtenir des fréquences de résonance plus faibles, donc plus de déplacement, donc plus de signal pour une même accélération.

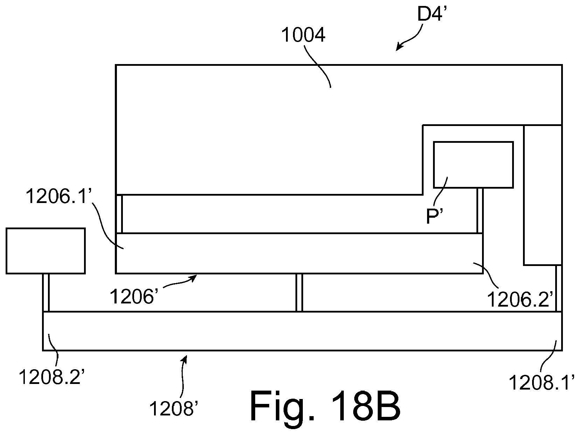

Sur la figure 18B, on peut voir un dispositif D12' selon une variante de réalisation du dispositif D12.

Les moyens de guidage comportent deux bras 1206', 1208' disposés dans deux plans parallèles et articulés l'un par rapport à l'autre par une articulation 1218'.

Une face latérale du bras 1206' est en regard d'une face latérale du bras 1208' et l'articulation 1218' s'étend entre les deux faces latérales.

Le bras 1208' situé le plus à l'extérieur par rapport à l'élément mobile 1004 présente une longueur supérieure à celle du bras 1206'.

De manière avantageuse, l'articulation est formée par une poutre déformable en torsion.

La liaison pivot entre la poutre 1206' et l'élément mobile est située au niveau d'une extrémité longitudinale 1206.1' de la poutre 1206', et la liaison pivot entre la poutre 1206' et le support est située au niveau de l'autre extrémité longitudinale 1206.2' de la poutre 1206'.

La liaison pivot entre la poutre 1208' et l'élément mobile 1004 est située au niveau d'une extrémité longitudinale 1208.1' de la poutre 1208' et la liaison pivot entre la poutre 1208' et le support est située au niveau de l'autre extrémité longitudinale 1208.2' de la poutre 1208'.

Le bras 1208' situé le plus à l'extérieur par rapport à l'élément mobile 1004 présente une longueur supérieure à celle du bras 1206', de sorte que les articulations pivots entre le bras 1208' et le support et entre le bras 1208'et l'élément mobile soient à l'extérieur du bras 1206' et ses articulations pivots. Ainsi, contrairement au dispositif D12, il n'y a pas de superposition entre une ou des articulations pivots et les bras.

Les liaisons pivots sont avantageusement réalisées par des poutres déformables en torsion.

Dans l'exemple représenté, l'élément mobile est structuré pour ménager un emplacement pour un plot d'ancrage P', ce qui permet de réduire l'encombrement. Il pourrait être prévu que l'élément mobile ne soit pas structuré et que le plot d'ancrage soit en avant de l'élément mobile dans l'exemple représenté.

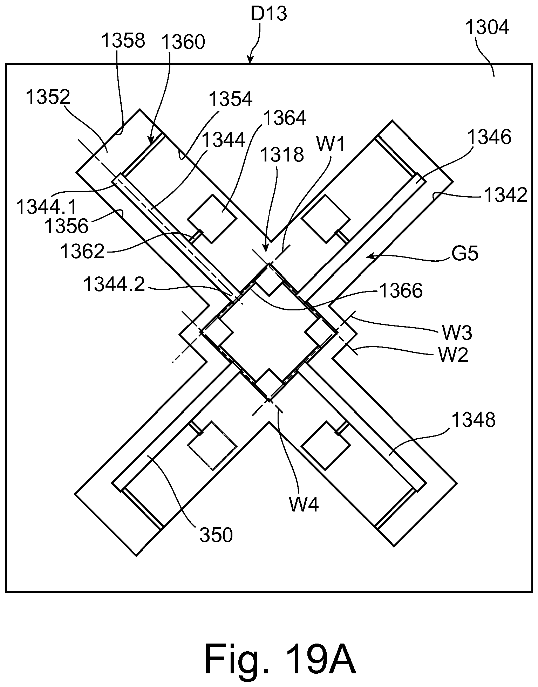

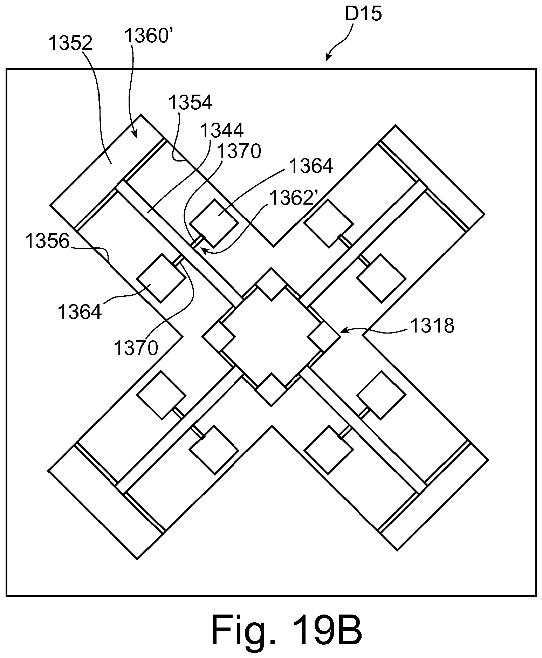

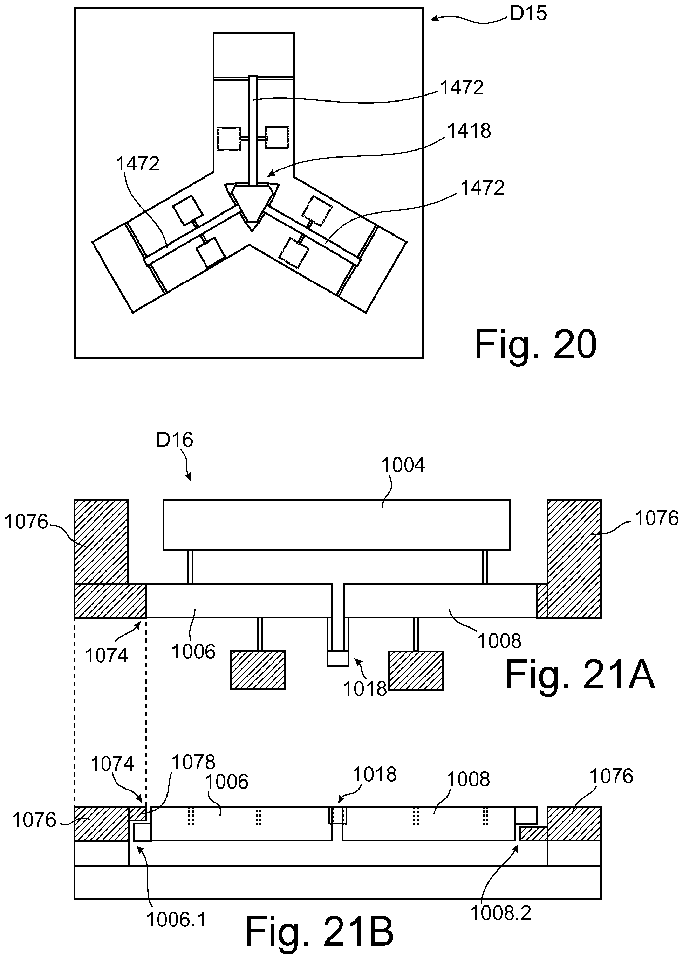

Sur les figures 19A, 19B et 20 on peut voir un dispositif selon un autre exemple de réalisation dans lequel les moyens de couplage sont situés à l'intérieur du périmètre de l'élément mobile.

Sur la figure 19A, le dispositif D13 comporte un élément mobile 1304 muni d'une fenêtre traversant l'élément mobile 1304 dans la direction Z, réalisée par exemple par gravure et des moyens de guidage G5 disposés dans la fenêtre 1342.

Les moyens de guidage G5 comportent quatre bras rigides 1344, 1346, 1348, 1350 articulés en rotation d'une part sur l'élément mobile, d'autre part sur le support et enfin sur une articulation de couplage 1318. Les axes des articulations pivots de chaque arbre sont parallèles entre eux.

Dans l'exemple représenté, la fenêtre 1342 a une forme de croix dont les branches s'étendent le long de diagonales de l'élément mobile de forme rectangulaire.

Les bras sont disposés les uns par rapport aux autres de sorte à former une croix correspondant à la fenêtre 1342.

Les quatre bras sont reliés à l'élément mobile, au support et à l'articulation de couplage de manière similaire, seules les liaisons du bras 1344 seront décrites en détail.

Le bras 3144 est disposé dans une branche 1352 de la fenêtre 1342.

La branche 1352 comporte deux bords latéraux 1354, 1356 reliés par un bord longitudinal 1358 situé à l'opposé du centre de la fenêtre.

Le bras 1344 est relié à l'élément mobile 1354 par une liaison pivot 1360 entre le bord latéral 1354 et une extrémité distale 1344.1 du bras.

Le bras est relié au support 1302 par une liaison pivot 1362 s'étendant entre une zone centrale du bras et un plot d'ancrage 1364 situé entre le bord latéral 1354 et le bras 1344. En variante, le plot d'ancrage peut être situé entre le bras 1354 et l'autre bord latéral 1356. Le bras 1344 est relié à l'articulation de couplage 1318 par son extrémité proximale 1344.2. Dans l'exemple représenté, l'articulation de couplage 1318 comporte un cadre formé de quatre poutres 366 connectées entre elles par des connecteurs rigides 1370.

Les poutres sont aptes à se déformer en torsion. L'extrémité proximale 1344.1 du bras 1344 est fixée à une des poutres 1366, de sorte que l'axe du bras 1344 et l'axe W1 de la poutre 1366 soient orthogonaux. Ainsi la liaison entre le bras 1344 et l'articulation de couplage est une liaison pivot d'axe W1.

Les liaisons pivots 1360 et 1362 sont formées par des poutres déformables en torsion.

Les autres bras 1344, 1346, 1348 et 1350 sont articulés en rotation sur l'articulation de couplage autour d'axe W1, W2, W3, W4, les axes W1et W3 étant parallèles et perpendiculaires aux axes W2 et W4 parallèles entre eux.

Le déplacement hors-plan de l'élément mobile est autorisé par les liaisons pivots et la déformation transversale de l'articulation de couplage, les poutres 1366 offrant une certaine aptitude à se déformer en flexion.

En variante, l'emplacement des liaisons pivots 1360 et 1362 pourraient être interverties, et/ou être situées à d'autres positions longitudinales du bras 1344.

Sur la figure 19B, on peut voir une variante D14 de réalisation du dispositif D13. La liaison pivot 1360' du dispositif D14 entre le bras 1344 et l'élément mobile est formée par une poutre s'étendant entre les deux bords latéraux 1354, 1356 de la branche de la fenêtre. La liaison pivot 1362' du dispositif D14 entre le bras 1344 et le support comporte deux poutres 1370 s'étendant de part et d'autre de l'axe du bras 1344 et ancrées chacune sur un plot d'ancrage. Le dispositif D14 offre l'avantage par rapport à D13 d'une meilleure tenue de la masse. En outre les efforts sont symétrisés.

En variante, il peut être envisagée que l'une des liaisons pivots 1354, 1356 soit celle de du dispositif D13 et l'autre des liaisons pivots 1356, 1354 soit celle du dispositif D14.

Sur la figure 20, on peut voir un autre exemple de réalisation D15, dans lequel les moyens de guidage G7 comportent trois bras 1472 articulés sur l'élément mobile et sur le support de manière similaire à celle décrite pour les dispositifs D13 et D14. Les bras sont couplés entre eux par une articulation de couplage 1418 formé par un cadre triangulaire comprenant trois poutres déformables en torsion et formant les liaisons pivots entre les bras et l'articulation de couplage.

Les axes des liaisons pivots entre d'une part le bras et l'élément mobile, d'autre part le bras et le support et enfin entre le bras et l'articulation de couplage sont parallèles entre eux.

Le dispositif D15 présente l'avantage par rapport aux dispositifs D13 et D14 d'avoir une réduction de masse plus faible en ne mettant en œuvre que trois bras et de présenter une fréquence de résonance plus basse, tout en assurant le maintien dans les deux directions.

Selon un autre exemple de réalisation, le moyen de guidage des dispositifs D13 à D15 peut ne comporter que deux bras reliés par une articulation de couplage et disposés dans une fenêtre traversant l'élément mobile.

Sur les figures 21A à 21C, on peut voir un exemple avantageux d'un dispositif D16 selon l'invention.

Le dispositif D16 a une structure similaire à celle du dispositif D9 et comporte en plus des moyens de butée hors-plan 1074

Les moyens de butée hors-plan sont à la fois portés par les moyens de guidage et le support.

Le support comporte des montants 1076 situés sur les bords latéraux des moyens de guidage de part et d'autre de l'articulation de couplage.

Dans l'exemple représenté et de manière avantageuse, les moyens de butée hors-plan sont bidirectionnels. Mais il sera compris que les moyens de butée ne pourraient former une butée que dans un sens de déplacement hors-plan.

Les articulations pivots entre les bras et l'élément mobile sont disposées de telle sorte que les extrémités distales 1006.1 et 1008.2 soient en saillie par rapport à ces articulations pivots dans la direction X.

L'un des montants 1076 comporte une saillie latérale 1078 s'étendant au-dessus de l'extrémité distale 1006.1 du bras 1006 en considérant la direction Z.

De manière avantageuse, l'extrémité distale 1006.1 est structurée ce qui permet de rapprocher les structures et de réduire l'encombrement selon la direction Z.

L'autre montant 1076 comporte une saillie latérale 1080 s'étendant au-dessous de l'extrémité distale 1008.2 du bras 1008 en considérant la direction Z. De manière avantageuse l'extrémité distale 1008.2 est structurée.

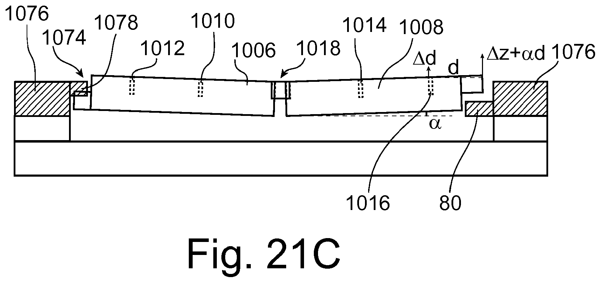

Sur la figure 21C, on peut voir l'extrémité distale 1006.1 du bras 1006 en butée contre la saillie latérale 1078 du montant 1076.

Dans cet exemple et de manière avantageuse, les moyens de butée interviennent avant que la masse n'entre en contact avec les électrodes destinées à la détection du déplacement. En effet, comme cela est schématisé sur la figure 21C, si l'élément mobile se déplace d'une distance Δz selon la direction Z en éloignement du support, que la distance entre la liaison pivot entre le bras et l'élément mobile et la butée est de d et que l'angle de pivotement des bras est a, alors l'extrémité distale 1006.1 se déplace de Δz + ad.

De manière avantageuse, les extrémités distales 1006.1, 1008.2 susceptibles de venir en contact avec les montants 1076 présentent une faible surface, ce qui réduit les risques de collage.

Dans d'autres exemples de réalisation, il peut être envisagé que les deux butées soient portées par le même bras, par exemple en structurant le bras.

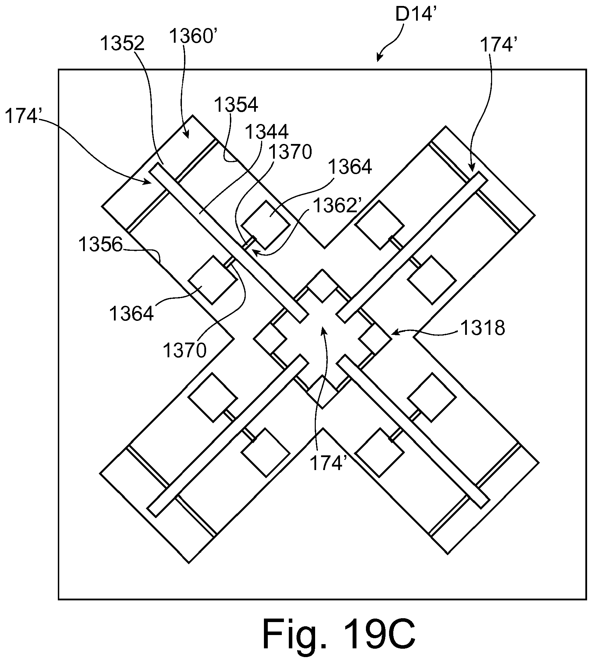

Sur la figure 19C, on peut voir une variante D14' de réalisation du dispositif D14 comporte de moyens de butée 174' formés par les extrémités longitudinales des bras qui sont telles que les axes des articulations pivots 1360', 1362'ne se situent pas au niveau des extrémités mais à des positions intermédiaires des bras. L'une ou l'autre des extrémités longitudinales de chaque bras vient en butée contre le support suivant le déplacement de la partie mobile.

Il sera compris que les moyens de butée hors-plan peuvent s'appliquer à tous les dispositifs D10 à D15 décrits ci-dessus.

Dans l'exemple des figures 13 et 14A et 14B, les moyens de guidage hors-plan G1 sont situés à l'extérieur de la structure. En variante, il peut être envisagé d'intervertir les moyens de suspension et les moyens de guidage, en disposant les moyens de guidage entre l'élément mobile et le plot d'ancrage 1034, et en disposant les moyens de suspension à l'extérieur.

Les moyens de guidage des figures 13 à 17 pourraient comporter plus de deux bras, par exemple quatre bras articulés les uns aux autres, sur l'élément mobile et sur le support.

En outre dans le cas d'un dispositif comportant plusieurs moyens de guidage selon l'invention, ceux-ci pourraient avoir des structures différentes.

Des exemples de procédé de fabrication d'un dispositif selon l'invention vont maintenant être décrits.

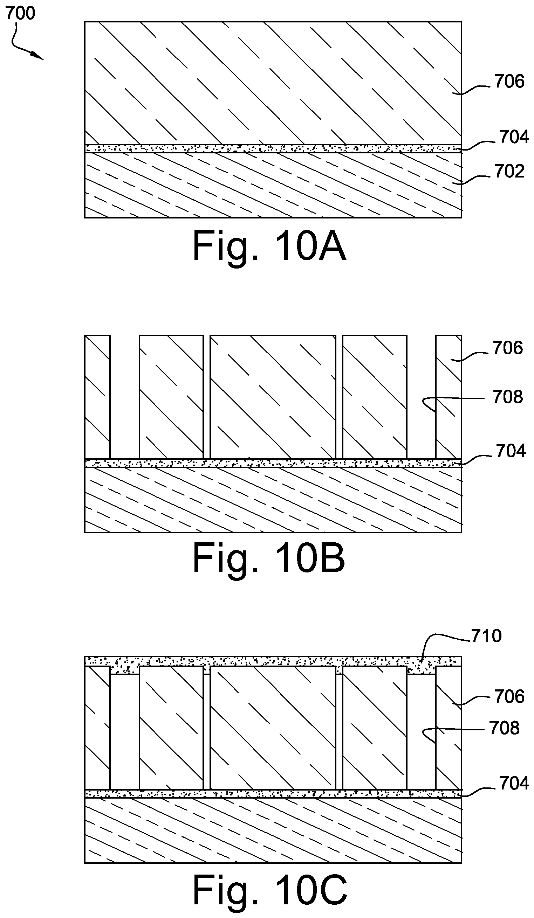

Sur les figures 10A à 10I, on peut voir représenté de manière schématique l'élément obtenu lors des différentes étapes d'un premier exemple de procédé de fabrication d'un dispositif selon l'invention. Le dispositif obtenu est le dispositif D3. Mais il sera compris que le procédé de fabrication est apte à réaliser tout dispositif selon l'invention.

On utilise un substrat silicium sur isolant ou SOI (Silicon on Insulator) 700, par exemple d'épaisseur 750 µm, comportant un support en silicium 702, une couche de SiO₂ 704 et une couche en silicium 706, la couche d'oxyde a par exemple une épaisseur de 2 µm. Ce substrat est représenté sur la figure 10A.

Lors d'une première étape, on réalise des tranchées 708 par gravure de la couche 706 avec arrêt sur la couche d'oxyde 704, par exemple par gravure ionique réactive profonde ou DRIE (Deep Reactive Ionic Etching), permettant de délimiter la partie mobile et les éléments d'ancrage de la partie fixe.

L'élément ainsi obtenu est représenté sur la figure 10B.

Lors d'une étape suivante, les tranchées 708 sont bouchées par exemple avec de l'oxyde 710. L'oxydation peut être formée par oxydation thermique, ce qui a pour effet de remplir partiellement les tranchées et/ou par dépôt de l'oxyde sur toute la surface du substrat pour recouvrir les tranchées. La couche d'oxyde 710 recouvre toute la face avant du substrat. Cette étape pourra être suivi d'un polissage mécano-chimique.

L'élément ainsi obtenu est représenté sur la figure 10C.

Lors d'une étape suivante, on structure la couche d'oxyde 710 pour former des accès à la couche de silicium 706 de sorte à permettre la formation des électrodes mobile et fixes, la structuration peut être réalisée par gravure RIE (Reactive ionic Etching). La structuration de la couche d'oxyde 710 servira également à la réalisation des liaisons pivots et des butées. La structuration peut être réalisée par gravure RIE (Reactive ionic Etching).

Ensuite une couche de silicium épaisse 712, par exemple d'épaisseur comprise entre quelques µm et quelques dizaines de µm est formée sur la couche d'oxyde structurée, par exemple par croissance épitaxiale. Le silicium est déposé dans les accès à la couche 706. En variante, un matériau conducteur différent de celui du substrat pourrait former la couche 712.

Un polissage mécano-chimique peut ensuite avoir lieu.

Les plots métalliques et d'éventuelles pistes sont ensuite réalisés sur la couche 712 par dépôt et structuration.

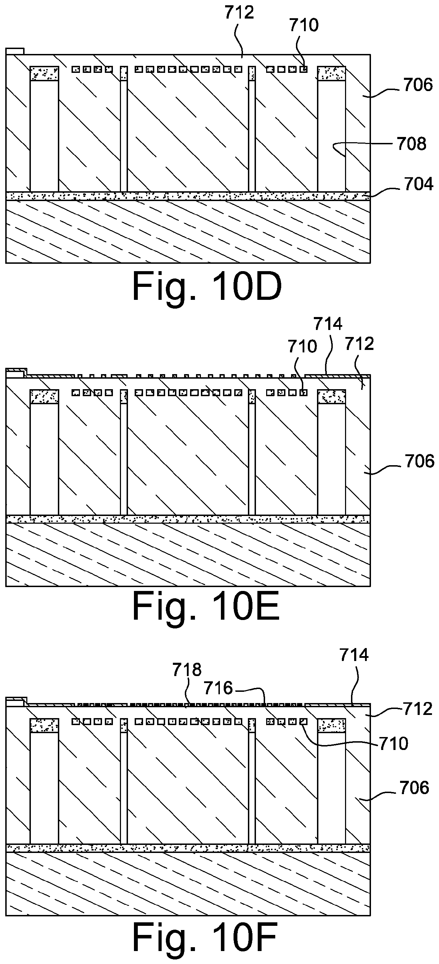

L'élément ainsi obtenu est représenté sur la figure 10D.

Lors d'une étape suivante, une couche d'oxyde 714 est formée sur la couche 712, par exemple par dépôt. Celle-ci est ensuite structurée par exemple par gravure RIE. Cette couche structurée est destinée à former un masque dur et à protéger des zones de la couche 712.

L'élément ainsi obtenu est représenté sur la figure 10E.

Lors d'une étape suivante, une couche de résine photosensible 716 est déposée et est structurée pour protéger des zones entre les zones recouvertes de masque dur qui seront partiellement gravées. Des zones 718 entre le masque dur 712 et le masque en résine 716 restent accessibles à un agent de gravure.

L'élément ainsi obtenu est représenté sur la figure 10F.

Lors d'une étape suivante, on effectue une gravure des zones accessibles 718 de la couche 712 par exemple par DRIE. Dans l'exemple représenté, la gravure se fait avec arrêt sur la couche 710.

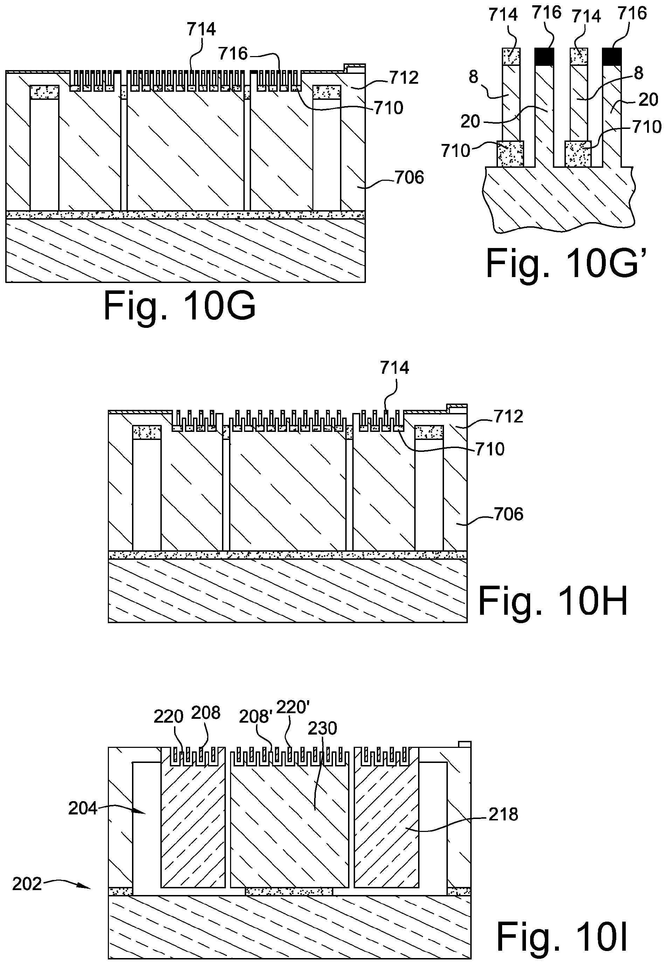

L'élément ainsi obtenu est représenté sur la figure 10G.

Lors de la structuration de la couche 712, les bras et les liaisons pivots et l'élément mobile sont au moins en partie délimité.

Dans cet exemple, l'élément mobile et les moyens de guidage sont réalisés d'un seul tenant. Dans un autre exemple, les moyens de guidage peuvent être réalisés dans la couche 706, dans ce cas l'élément mobile et les moyens de guidage ne sont pas d'un seul tenant.

Selon un autre exemple de réalisation particulièrement avantageux, on utilise une gravure arrêtée sur la couche 710 pour réaliser les électrodes suspendues 8, cette même gravure (figure 2) est arrêtée au temps pour réaliser les électrodes 20. Pour cela la couche 710 est structurée à l'étape représentée sur la figure (10D) de sorte, vue en coupe, que la largeur des portions de couche 710 restantes après gravure soient inférieure à la distance entre les électrodes 20 comme cela est représenté sur la figure 10G'. Ainsi les flancs des électrodes 20 sont obtenus uniquement par la gravure au temps et sont planes. On pallie ainsi un risque de désalignement entre les masques et les portions 710. La gravure au temps s'arrête entre les portions ou ilots de couche 710 ou au-delà dans le sens d'avancement de la gravure.

Lors d'une étape suivante, la couche de résine 716 est retirée et on effectue une gravure partielle de la couche 712 située à l'aplomb des anciens emplacements de la résine716. Les électrodes mobiles et fixes sont désormais réalisées et sont partiellement en regard les unes des autres. La gravure partielle est par exemple une gravure maîtrisée au temps

L'élément ainsi obtenu est représenté sur la figure 10H.

Lors d'une étape suivante, la structure est libérée en gravant l'oxyde 710 et l'oxyde 704 par exemple avec de l'acide fluorhydrique gazeux à travers des passages dans la structure (non représentés). Il s'agit d'une gravure au temps.

L'élément ainsi obtenu est représenté sur la figure 10I.

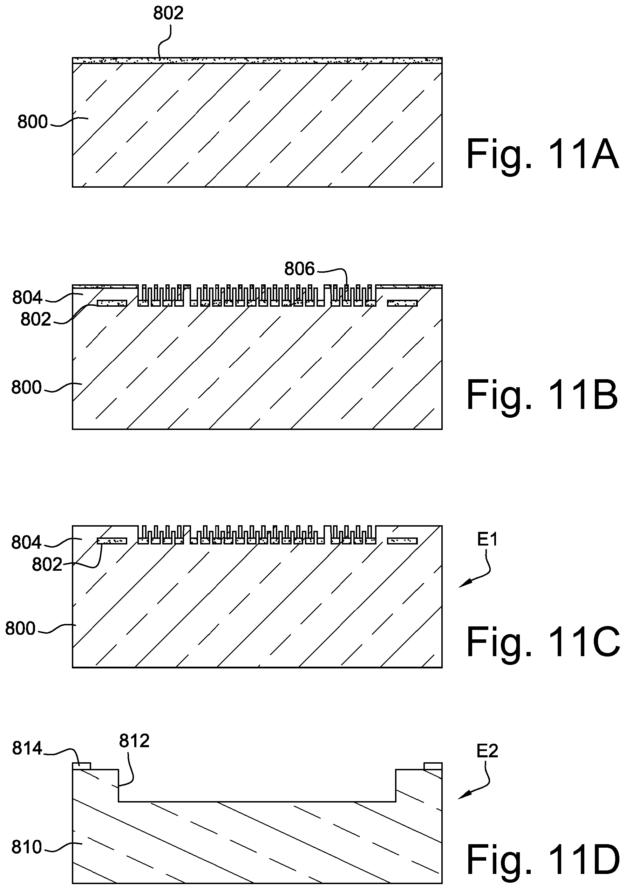

Un autre exemple de procédé de fabrication va être décrit en relation avec les figures 11A à 11I. Cet exemple de procédé présente l'avantage de ne pas utiliser de substrat SOI, le coût de revient est alors réduit. En outre, l'épaisseur de la partie mobile, notamment de la masse peut être choisie.

D'une part, on utilise un premier substrat 800 en matériau conducteur ou semi-conducteur, par exemple en silicium ayant par exemple une épaisseur de 750 µm.

Lors d'une première étape on forme une couche sacrificielle 802, par exemple par dépôt, sur l'une des faces du substrat 800, par exemple en oxyde d'une épaisseur par exemple de 3 µm.

L'élément est représenté sur la figure 11A.

Lors d'étapes suivantes qui sont similaires à celles associées aux figures 10D à 10G, en formant une couche de silicium 804 et une couche d'oxyde 806. On structure les électrodes fixes et mobiles.

L'élément ainsi obtenu est représenté sur la figure 11B.

Lors d'une étape suivante a lieu une étape de gravure similaire à la gravure partielle des doigts en silicium, tel que décrite en relation avec la figure 10H.

L'élément désigné E1 ainsi obtenu est représenté sur la figure 11C.

D'autre part, on utilise un deuxième substrat conducteur ou semi-conducteur 810, typiquement d'épaisseur 750 µm, dans lequel une cavité 812 est gravée en face avant et des plots métalliques 814 sont formées sur la face avant.

L'élément désigné E2 ainsi obtenu est représenté sur la figure 11D.

Lors d'une étape suivante, les éléments E1 et E2 sont collées par collage eutectique au moyen des plots 814 de sorte que les électrodes sont en regard de la cavité 812. En variante, un collage direct est envisageable.

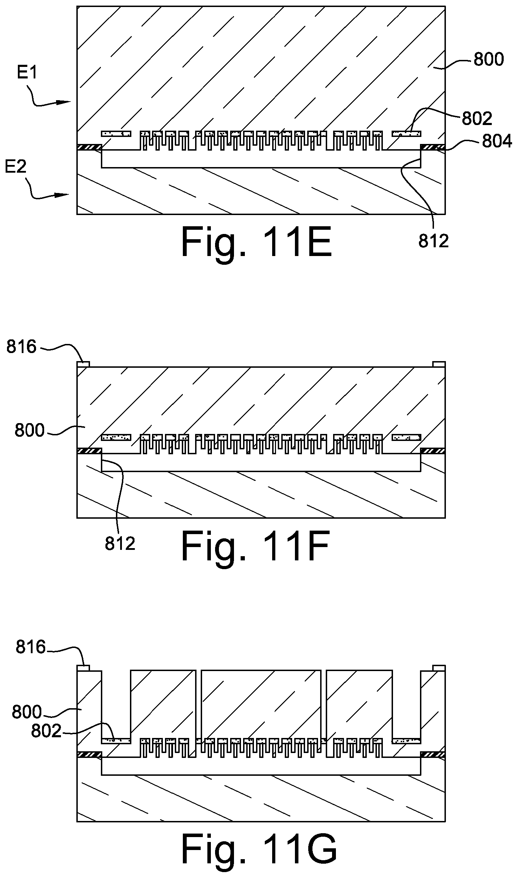

L'élément ainsi obtenu est représenté sur la figure 11E.

Lors d'une étape suivante, le premier substrat 800 est aminci par exemple par meulage (Grinding en terminologie anglo-saxonne) puis polissage mécano-chimique, ou par gravure RIE puis CMP et des contacts électriques 816 sont réalisés sur en face arrière.

L'élément ainsi obtenu est représenté sur la figure 11F.

Lors d'une étape suivante, le substrat 800 est structuré pour définir la partie mobile et les éléments d'ancrage, par exemple en gravant le substrat 800 sur toute son épaisseur avec arrêt sur la couche 802, par exemple par DRIE.

L'élément ainsi obtenu est représenté sur la figure 11G.

Lors d'une étape suivante, on libère la structure en gravant la couche d'oxyde 802, par exemple par acide fluorhydrique gazeux.

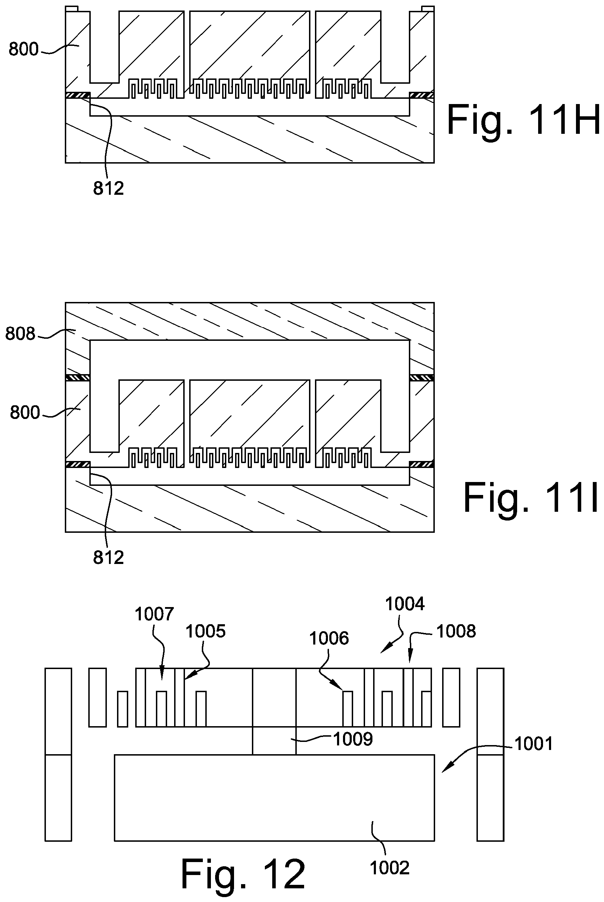

L'élément ainsi obtenu est représenté sur la figure 11H.

De manière optionnelle, un capot 808 peut être rapporté pour encapsuler le dispositif, par exemple par collage, tel que le scellement polymère ou le scellement eutectique.

L'élément ainsi obtenu est représenté sur la figure 11I.

Le procédé des figures 11A à 11I est particulièrement adapté à la réalisation d'un actionneur pour micro-miroir. En effet le miroir peut être aisément réalisé en face arrière du substrat 800.

Le dispositif selon l'invention offre donc des électrodes de détection ou d'actionnement à variation de surface à déplacement hors-plan, permettant une transduction électromécanique linéaire, bidirectionnelle. La détection peut être avantageusement différentielle. En outre elle permet d'offrir une grande densité capacitive, le dispositif peut alors offrir une grande sensibilité de détection et une force d'actionnement importante tout en utilisant des tensions faibles. Par exemple dans le cas de micro-miroirs MEMS, toute la face arrière du support du miroir peut comporter des électrodes, le facteur de remplissage peut être maximisé et permet de réduire la surface utilisée pour l'actionnement et de réduire les coûts de production.

L'invention permet d'optimiser d'une part la partie mécanique, la masse dans le cas d'un capteur inertielle ou la partie actionneur telle que la surface du miroir, et d'autre part la partie capacitive servant à la détection et/ou à l'actionnement.

Le dispositif peut également être avantageusement mis en œuvre pour réaliser un gyromètre.

## Revendications

1. Dispositif microélectromécanique et/ou nanoélectromécanique comportant au moins deux ensembles, un ensemble désigné premier ensemble et un ensemble désigné deuxième ensemble, chaque premier et deuxième ensemble comprenant au moins une première partie (2, 102) et au moins une deuxième partie (4, 104) apte à se déplacer l'une par rapport à l'autre au moins dans une direction de déplacement hors-plan (Z), la première partie (2, 102) comportant un premier support et au moins des premières électrodes (8, 108, 108') s'étendant parallèlement à la direction de déplacement (Z), la deuxième partie (4, 104) comportant un deuxième support et au moins des deuxièmes électrodes (20, 120, 120') s'étendant parallèlement à ladite direction de déplacement hors-plan (Z), les premières électrodes (8, 108, 108') et les deuxièmes électrodes (20, 120, 120') étant disposées les unes par rapport aux autres de sorte à être interdigitées, le deuxième support comportant au moins une face perpendiculaire à la direction de déplacement hors-plan (Z), les premières électrodes (8, 108, 108') comportant une première extrémité et une deuxième extrémité dans la direction de déplacement les deuxième électrodes (20, 120, 120') comportant une première extrémité et une deuxième extrémité dans la direction de déplacement, dans lequel les deuxièmes électrodes (20, 120, 120') ont leur deuxième extrémité directement connectée à la face du deuxième support et ont leur première extrémité disposée entre les deux extrémités de la premières électrodes (8, 108, 108') de sorte qu'une partie seulement de la face de chaque deuxième électrode (20, 120, 120') soit en regard d'une première électrode (8, 108, 108') au repos, **caractérisé en ce que**
la première partie du premier
ensemble est reliée mécaniquement à la deuxième partie du deuxième ensemble, et la deuxième partie du premier ensemble est reliée mécaniquement à la première partie du deuxième ensemble, et dans lequel les premier et deuxième ensembles sont disposés l'un par rapport à l'autre de sorte que, lorsque le premier support de la première partie du premier ensemble se rapproche du deuxième support de la deuxième partie du premier ensemble, le premier support de la première partie du deuxième ensemble s'éloigne du deuxième support de la deuxième partie du deuxième ensemble, et inversement.

2. Dispositif selon la revendication 1, dans lequel au moins une desdites première ou deuxième parties est mobile et l'autre desdites première ou deuxième parties est fixe.

3. Dispositif selon la revendication 1, dans lequel lesdites première ou deuxième parties sont toutes les deux mobiles et se déplacent l'une par rapport à l'autre

4. Dispositif selon la revendication 2 ou 3, dans lequel la première et/ou la deuxième partie est (sont) mobile(s) et dans lequel une partie au moins dudit premier et/ou dudit deuxième support forme une masse inertielle (18), avantageusement la partie du premier support formant une masse inertielle et étant suspendue à la deuxième partie et/ou la partie du deuxième support formant une masse inertielle et étant suspendue à la première partie.

5. Dispositif selon l'une des revendications 1 à 4, dans lequel la première partie du premier ensemble et la deuxième partie du deuxième ensemble sont isolées électriquement l'une de l'autre et/ou la deuxième partie du premier ensemble et la première partie du deuxième ensemble sont isolées électriquement l'une de l'autre.

6. Dispositif selon l'un des revendications 1 à 5, dans lequel le deuxième support du premier ensemble et le deuxième support du deuxième ensemble sont situés à l'opposé du premier support du premier ensemble et du premier support du deuxième ensemble par rapport à un plan perpendiculaire à la direction hors-plan.

7. Dispositif selon la revendication 6, dans lequel le deuxième support formant masse inertielle du premier ensemble entoure le deuxième support du deuxième ensemble, et dans lequel la première partie du premier ensemble comporte au moins deux portions suspendues polarisables séparément et disposées de manière symétrique par rapport à un plan de symétrie du dispositif contenant la direction de déplacement hors-plan, ou dans lequel le deuxième support formant masse inertielle du premier ensemble comporte quatre logements pour recevoir quatre deuxièmes supports du deuxième ensemble, dans lequel les deuxièmes électrodes du premier ensemble sont disposées en forme de croix entre les quatre logements, et dans lequel le deuxième ensemble comporte quatre premiers supports suspendus au deuxième support du premier ensemble.

8. Dispositif selon l'une des revendications 1 à 7, dans lequel pour chaque ensemble, les premières électrodes et les deuxièmes électrodes ont une section transversale telle que les premières ou les deuxièmes électrodes entourent les deuxièmes ou les premières électrodes respectivement de manière continue.

9. Dispositif selon l'une des revendications 1 à 8, comportant au moins un moyen de guidage (G1, G5) des premières parties et/ou des deuxièmes parties, dans la direction de déplacement hors-plan, ledit le moyen de guidage (G1) étant avantageusement disposé le long d'au moins un bord extérieur de l'élément mobile (4).

10. Dispositif selon la revendication 9, comportant au moins un moyen de guidage (G1, G5) en translation des premières parties et/ou des deuxièmes parties, ledit moyen de guidage (G1, G5) comportant au moins deux bras rigides s'étendant longitudinalement, une articulation pivot entre chaque bras et les premières parties et/ou les deuxièmes parties et une articulation pivot entre chaque bras et le support, le moyen de guidage (G1, G5) comportant également une articulation de couplage entre les deux bras comportant au moins une articulation pivot, au moins deux des articulations pivot reliées à chacun des bras ayant un degré de liberté en translation dans le plan du dispositif le long des bras, les articulations pivots ayant un degré de liberté en translation comportant avantageusement au moins une poutre déformable en torsion, lesdites articulations pivots ayant des axes de rotation au moins parallèles entre eux de sorte que, lors d'un déplacement en translation des premières parties et/ou des deuxièmes parties, les bras pivotent l'un par rapport à l'autre dans des sens opposés.

11. Dispositif selon la revendication 9 ou 10, comportant au moins deux moyens de guidage, les axes de rotation des deux moyens de guidage étant avantageusement sécants entre eux.

12. Dispositif de détection capacitif comportant au moins un dispositif selon l'une des revendications 1 à 11.

13. Actionneur comportant au moins un dispositif selon l'une des revendications 1 à 11, la partie mobile étant par exemple suspendue à la partie fixe par une articulation pivot.

14. Dispositif à micromiroir comportant au moins un actionneur selon la revendication 13, dans lequel le support mobile comporte une deuxième face opposée à la première face, comportant une surface réflechissante formant miroir.

15. Gyromètre comportant au moins un dispositif selon l'une des revendications 1 à 11 formant un actionneur et/ou un dispositif de détection.

16. Procédé de fabrication d'un dispositif selon l'une des revendications 1 à 11, à partir d'un premier substrat comportant au moins une première couche en matériau conducteur électrique épaisse, comportant les étapes :
a) formation d'une couche sacrificielle (710, 802) sur la première couche en matériau conducteur électrique (706, 800),
b) formation de premières tranchées dans la première couche sacrificielle (710, 802) jusqu'à la première couche en matériau conducteur électrique (706, 800) de sorte à former des îlots de seconde couche sacrificielle (710, 802),
c) formation d'une deuxième couche de matériau conducteur électrique (712, 804) sur la première couche sacrificielle (710, 802) et dans les premières tranchées, avantageusement par croissance par épitaxie.
d) structuration de ladite deuxième couche en matériau conducteur électrique (712, 804) de sorte à former des deuxièmes tranchées débouchant au moins en partie sur les îlots de deuxième couche sacrificielle, l'élément ainsi formé comportant des premières portions de la deuxième couche en matériau conducteur électrique (712, 804) en contact avec la première couche en matériau conducteur électrique (706, 800) et destinées à former les deuxièmes électrodes et des deuxièmes portions de la deuxième couche de matériau conducteur électrique (712, 804) en contact avec les ilots de deuxième couche sacrificielle, destinées à former les premières électrodes,
e) gravure partielle des premières portions,
f) libération de la structure.

17. Procédé de fabrication selon la revendication 16, dans lequel lors de l'étape d), les premières électrodes sont formées par une gravure avec arrêt sur les ilots de deuxième couche sacrificielle et les deuxièmes électrodes sont formées par ladite gravure avec arrêt au temps entre les ilots de deuxième couche sacrificielle ou au-delà dans le sens de la gravure, et ou dans lequel l'étape d) comporte la formation d'un masque dur (714, 806) sur la deuxième couche de matériau conducteur électrique (712, 804), la structuration dudit masque dur (714, 806) aux emplacements des deuxièmes portions, et la formation d'un masque en résine photosensible (716) aux emplacements des premières portions, et/ou ledit procédé comportant entre l'étape e) et l'étape f) la réalisation d'un deuxième substrat (810) muni d'une cavité (812), d'assemblage du deuxième substrat (810) avec le premier substrat de sorte que les premières et deuxièmes portions soient en regard de la cavité (812) et de réalisation de troisièmes tranchées dans le premier substrat à partir de la face arrière jusqu'à la première couche sacrificielle (802), de sorte à délimiter la partie mobile, ledit procédé comportant avantageusement une étape d'assemblage d'un capot (808) sur le deuxième substrat.

18. Procédé de fabrication selon la revendication 16 ou 17, dans lequel le premier substrat est un substrat silicium sur isolant, le procédé de fabrication comportant préalablement à l'étape a) la formation de quatrièmes tranchées (708) dans la première couche en matériau conducteur électrique (706) jusqu'à une couche d'oxyde (704) du premier substrat de sorte à délimiter la partie mobile, et dans lequel lors de l'étape a) la première couche sacrificielle (710) est formée sur la première couche en matériau conducteur électrique (706) de sorte à recouvrir la première couche en matériau conducteur électrique (706) et à au moins obturer les quatrièmes tranchées (708).

## Patentansprüche

1. Mikroelektromechanische und/oder nanoelektromechanische Vorrichtung, umfassend wenigstens zwei Baugruppen, nämlich eine als erste Baugruppe bezeichnete Baugruppe und eine als zweite Baugruppe bezeichnete Baugruppe, wobei sowohl die erste als auch die zweite Baugruppe wenigstens einen ersten Teil (2, 102) und wenigstens einen zweiten Teil (4, 104) umfasst, die dazu ausgelegt sind, sich relativ zueinander wenigstens in einer Verlagerungsrichtung aus der Ebene (Z) zu verlagern, wobei der erste Teil (2, 102) einen ersten Träger und wenigstens erste Elektroden (8, 108, 108') umfasst, die sich parallel zur Verlagerungsrichtung (Z) erstrecken, wobei der zweite Teil (4, 104) einen zweiten Träger und wenigstens zweite Elektroden (20, 120, 120') umfasst, die sich parallel zur Verlagerungsrichtung aus der Ebene (Z) erstrecken, wobei die ersten Elektroden (8, 108, 108') und die zweiten Elektroden (20, 120, 120') relativ zueinander derart angeordnet sind, dass sie interdigital sind, wobei der zweite Träger wenigstens eine Fläche orthogonal zur Verlagerungsrichtung aus der Ebene (Z) umfasst, wobei die ersten Elektroden (8, 108, 108') ein erstes Ende und ein zweites Ende in der Verlagerungsrichtung umfassen, wobei die zweiten Elektroden (20, 120, 120') ein erstes Ende und ein zweites Ende in der Verlagerungsrichtung umfassen, wobei die zweiten Elektroden (20, 120, 120') ihr zweites Ende direkt mit der Fläche des zweiten Trägers verbunden haben und ihr erstes Ende zwischen den zwei Enden der ersten Elektroden (8, 108, 108') angeordnet haben, derart, dass nur ein Teil der Fläche von jeder zweiten Elektrode (20, 120, 120') gegenüber einer ersten Elektrode (8, 108, 108') im Ruhezustand ist,
**dadurch gekennzeichnet, dass** der erste Teil der ersten Baugruppe mechanisch mit dem zweiten Teil der zweiten Baugruppe verbunden ist, und dass der zweite Teil der ersten Baugruppe mechanisch mit dem ersten Teil der zweiten Baugruppe verbunden ist, und wobei die erste und die zweite Baugruppe relativ zueinander derart angeordnet sind, dass dann, wenn sich der erste Träger des ersten Teils der ersten Baugruppe dem zweiten Träger des zweiten Teils der ersten Baugruppe nähert, der erste Träger des ersten Teils der zweiten Baugruppe sich vom zweiten Träger des zweiten Teils der zweiten Baugruppe entfernt, und umgekehrt.

2. Vorrichtung nach Anspruch 1, bei der wenigstens einer von dem ersten oder zweiten Teil beweglich ist, und der andere von dem ersten oder zweiten Teil fest ist.

3. Vorrichtung nach Anspruch 1, bei der das erste oder das zweite Teil beide beweglich sind und sich relativ zueinander verlagern.

4. Vorrichtung nach Anspruch 2 oder 3, bei der das erste und/oder das zweite Teil beweglich ist (sind), und bei der wenigstens ein Teil des ersten und/oder des zweiten Trägers eine träge Masse (18) bildet, wobei vorzugsweise der Teil des ersten Trägers eine träge Masse bildet und an dem zweiten Teil aufgehängt ist, und/oder der Teil des zweiten Trägers eine träge Masse bildet und am ersten Teil aufgehängt ist.

5. Vorrichtung nach einem der Ansprüche 1 bis 4, bei der der erste Teil der ersten Baugruppe und der zweite Teil der zweiten Baugruppe voneinander elektrisch isoliert sind, und/oder der zweite Teil der ersten Baugruppe und der erste Teil der zweiten Baugruppe elektrisch voneinander isoliert sind.

6. Vorrichtung nach einem der Ansprüche 1 bis 5, bei dem der zweite Träger der ersten Baugruppe und der zweite Träger der zweiten Baugruppe bezogen auf eine Ebene orthogonal zu der Richtung aus der Ebene entgegengesetzt zu dem ersten Träger der ersten Baugruppe und zu dem ersten Träger der zweiten Baugruppe angeordnet sind.

7. Vorrichtung nach Anspruch 6, bei der der eine träge Masse bildende zweite Träger der ersten Baugruppe den zweiten Träger der zweiten Baugruppe umgibt, und bei der der erste Teil der ersten Baugruppe wenigstens zwei aufgehängte Bereiche umfasst, die separat polarisierbar sind und auf symmetrische Weise bezüglich einer Symmetrieebene der Vorrichtung angeordnet sind, die die Verlagerungsrichtung aus der Ebene enthält, oder bei der der eine träge Masse bildende zweite Träger der ersten Baugruppe vier Aufnahmen zum Empfangen von vier zweiten Trägern der zweiten Baugruppe umfasst, wobei die zweiten Elektroden der ersten Baugruppe kreuzförmig zwischen den vier Aufnahmen angeordnet sind, und wobei die zweite Baugruppe vier erste Träger umfasst, die am zweiten Träger der ersten Baugruppe aufgehängt sind.

8. Vorrichtung nach einem der Ansprüche 1 bis 7, bei der für jede Baugruppe die ersten Elektroden und die zweiten Elektroden einen transversalen Querschnitt derart haben, dass die ersten oder die zweiten Elektroden die zweiten beziehungsweise die ersten Elektroden durchgehend umgeben.

9. Vorrichtung nach einem der Ansprüche 1 bis 8, umfassend wenigstens ein Führungsmittel (G1, G5) für die ersten Teile und/oder die zweiten Teile in der Verlagerungsrichtung aus der Ebene, wobei das Führungsmittel (G1) vorzugsweise entlang wenigstens eines äußeren Rands des beweglichen Elements (4) angeordnet ist.

10. Vorrichtung nach Anspruch 9, umfassend wenigstens ein Führungsmittel (G1, G5) in Translation für die ersten Teile und/oder die zweiten Teile, wobei das Führungsmittel (G1, G5) wenigstens zwei starre Arme umfasst, die sich longitudinal erstrecken, sowie ein Schwenkgelenk zwischen jedem Arm und den ersten Teilen und/oder den zweiten Teilen und ein Schwenkgelenk zwischen jedem Arm und dem Träger, wobei das Führungsmittel (G1, G5) ferner ein Kopplungsgelenk zwischen den zwei Armen umfasst, umfassend wenigstens ein Schwenkgelenk, wobei wenigstens zwei der Schwenkgelenke, die mit jedem der Arme verbunden sind, einen Translationsfreiheitsgrad in der Ebene der Vorrichtung entlang der Arme haben, wobei die Schwenkgelenke, die einen Translationsfreiheitsgrad haben, vorzugsweise wenigstens einen torsionsverformbaren Balken umfassen, wobei die Schwenkgelenke Drehachsen haben, die wenigstens zueinander parallel sind, derart, dass bei einer Translationsverlagerung der ersten Teile und/oder der zweiten Teile die Arme relativ zueinander in entgegengesetzten Richtungen schwenken.

11. Vorrichtung nach Anspruch 9 oder 10, umfassend wenigstens zwei Führungsmittel, wobei die Drehachsen der zwei Führungsmittel sich vorzugsweise schneiden.

12. Kapazitive Detektionsvorrichtung, umfassend wenigstens eine Vorrichtung nach einem der Ansprüche 1 bis 11.

13. Aktor, umfassend wenigstens eine Vorrichtung nach einem der Ansprüche 1 bis 11, wobei der bewegliche Teil beispielsweise an dem festen Teil mittels eines Schwenkgelenks aufgehängt ist.

14. Mikrospiegelvorrichtung, umfassend wenigstens einen Aktor nach Anspruch 13, wobei der bewegliche Träger eine zweite Fläche entgegengesetzt zu der ersten Fläche umfasst, umfassend eine reflektierende Oberfläche, die einen Spiegel bildet.

15. Gyrometer, umfassen wenigstens eine Vorrichtung nach einem der Ansprüche 1 bis 11, die einen Aktor und/oder eine Detektionsvorrichtung bildet.

16. Verfahren zur Herstellung einer Vorrichtung nach einem der Ansprüche 1 bis 11 ausgehend von einem ersten Substrat, das wenigstens eine erste dicke Schicht aus einem elektrisch leitenden Material umfasst, umfassend die folgenden Schritte:
a) Bilden einer Opferschicht (710, 802) auf der ersten Schicht aus elektrisch leitendem Material (706, 800),
b) Bilden von ersten Gräben in der ersten Opferschicht (710, 802) bis zur ersten Schicht aus elektrisch leitendem Material (706, 800) derart, dass Inseln einer zweiten Opferschicht (710, 802) gebildet werden,
c) Bilden einer zweiten Schicht aus elektrisch leitendem Material (712, 804) auf der ersten Opferschicht (710, 802) und in den ersten Gräben, vorzugsweise durch epitaktisches Aufwachsen,
d) Strukturieren der zweiten Schicht aus elektrisch leitendem Material (712, 804) derart, dass zweite Gräben gebildet werden, die wenigstens teilweise auf die Inseln der zweiten Opferschicht münden, wobei das derart gebildete Element erste Bereiche der zweiten Schicht aus elektrisch leitendem Material (712, 804) in Kontakt mit der ersten Schicht aus elektrisch leitendem Material (706, 800) umfasst, die dazu ausgelegt sind, die zweiten Elektroden zu bilden, und zweite Bereiche der zweiten Schicht aus elektrisch leitendem Material (712, 804) in Kontakt mit den Inseln der zweiten Opferschicht, die dazu ausgelegt sind, die ersten Elektroden zu bilden,
e) partielles Ätzen der ersten Bereiche,
f) Freisetzen der Struktur.

17. Herstellungsverfahren nach Anspruch 16, bei dem während des Schritts d) die ersten Elektroden durch ein Ätzen mit einem Stopp auf den Inseln der zweiten Opferschicht gebildet werden, und die zweiten Elektroden durch das Ätzen mit einem zeitlichen Stopp zwischen den Inseln der zweiten Opferschicht oder darüber hinaus in der Ätzrichtung gebildet werden, und/oder wobei der Schritt d) das Bilden einer harten Maske (714, 806) auf der zweiten Schicht aus elektrisch leitendem Material (712, 804) umfasst, die Strukturierung der harten Maske (714, 806) an den Stellen der zweiten Bereiche, und das Bilden einer Maske aus fotoempfindlichen Harz (716) an den Stellen der ersten Bereiche, und/oder wobei das Verfahren zwischen dem Schritt d) und dem Schritt f) die Realisierung eines zweiten Substrats (810) umfasst, das mit einem Hohlraum (812) ausgestattet ist, ein Zusammenfügen des zweiten Substrats (810) mit dem ersten Substrat derart, dass die ersten und die zweiten Bereiche gegenüber dem Hohlraum (812) sind, und eine Realisierung von dritten Gräben in dem ersten Substrat ausgehend von der Rückfläche bis zur ersten Opferschicht (802) derart, dass der bewegliche Teil begrenzt wird, wobei das Verfahren vorzugsweise einen Schritt des Anfügens eines Deckels (808) auf dem zweiten Substrat umfasst.

18. Herstellungsverfahren nach Anspruch 16 oder 17, bei dem das erste Substrat ein Substrat Silizium auf Isolator ist, wobei das Herstellungsverfahren vor dem Schritt a) das Bilden von vierten Gräben (708) in der ersten Schicht aus elektrisch leitendem Material (706) bis zu einer Oxidschicht (704) des ersten Substrats umfasst, derart, dass der bewegliche Teil begrenzt wird, und wobei während des Schritts a) die erste Opferschicht (710) auf der ersten Schicht aus elektrisch leitendem Material (706) derart gebildet wird, dass sie die erste Schicht aus elektrisch leitendem Material (706) bedeckt und wenigstens die vierten Gräben (708) verschließt.

## Claims

1. Microelectromechanical and/or nanoelectromechanical device comprising at least two assemblies, one assembly called the first assembly and one assembly called the second assembly, each first and second assembly comprising at least one first part (2, 102) and at least one second part (4, 104) free to move relative to each other at least in an out-of-plane direction (Z), the first part (2, 102) comprising a first support and at least first electrodes (8, 108, 108') extending parallel to the direction of displacement (Z), the second part (4, 104) comprising a second support and at least second electrodes (20, 120, 120') extending parallel to said out-of-plane displacement direction (Z), the first electrodes (8, 108, 108') and the second electrodes (20, 120, 120') being arranged relative to each other such that they are interdigitated, the second support comprising at least one face perpendicular to the out-of-plane displacement direction (Z), the first electrodes (8, 108, 108') comprising a first end and a second end in the direction of displacement, the second electrodes (20, 120, 120') comprising a first end and a second end in the direction of displacement, in which the second ends of the second electrodes (20, 120, 120') are directly connected to the face of the second support and their first end is located between the two ends of the first electrodes (8, 108, 108') such that only part of the face of each second electrode (20, 120, 120') is facing a first electrode (8, 108, 108') at rest, **characterized in that** the first part of the first assembly is mechanically connected to the second part of the second assembly and the second part of the first assembly is mechanically connected to the first part of the second assembly and wherein the first assembly and the second assembly are located with respect to each other so that when the first support of the first part of the first assembly comes closer to the second support of the second part of the first assembly, the first support of the first part of the second assembly moves away from the second support of the second part of the second assembly, and vice versa.

2. Device according to claim 1, in which at least one of said first or second parts is mobile and the other of said first or second parts is fixed.

3. Device according to claim 1, in which said first or second parts are both mobile and displace relative to each other.

4. Device according to claim 2 or 3, in which the first and/or the second parts is (are) mobile and in which at least part of said first and/or said second support forms an inertial mass (18), advantageously the part of the first support forming an inertial mass is suspended from the second part and/or the part of the second support forming an inertial mass is suspended from the first part.

5. Device according to one of claims 1 to 4, in which the first part of the first assembly and the second part of the second assembly are electrically insulated from each other, and/or the second part of the first assembly and the first part of the second assembly are electrically insulated from each other.

6. Device according to one of claims 1 to 5, in which the second support of the first assembly and the second support of the second assembly are located on one side of a plane perpendicular to the out-of-plane direction, and the first support of the first assembly and the first support of the second assembly are located on another side of said plane.

7. Device according to claim 6, in which the second support forming an inertial mass of the first assembly surrounds the second support of the second assembly, and in which the first part of the first assembly comprises at least two suspended portions that can be polarised separately and are arranged symmetrically on opposite sides of a plane of symmetry of the device containing the direction of the out-of-plane displacement, or in which the second support forming the inertial mass of the first assembly comprises four housings to hold four second supports of the second assembly, in which the second electrodes of the first assembly form a cross between the four housings, and in which the second assembly comprises four first supports suspended from the second support of the first assembly.

8. Device according to one of claims 1 to 7, in which, for each assembly, the cross-section of the first electrodes and the second electrodes are such that the first or the second electrodes continuously surround the second or first electrodes respectively.

9. Device according to one of claims 1 to 8, comprising at least one guiding means (G1, G5) of the first parts and/or the second parts, along the out-of-plane displacement direction, said guiding means (G1) being advantageously located along at least one outside edge of the mobile part.

10. Device according to claim 9, comprising at least one guiding means (G1, G5) for guiding the first parts and/or the second parts in translation, said guiding means (G1, G5) comprising at least two rigid arms extending in the longitudinal direction, a pivot articulation between each arm and the first parts and/or the second parts, and a pivot articulation between each arm and the support, the guiding means (G1, G5) also comprising a coupling articulation between the two arms comprising at least one pivot articulation, at least two of the pivot articulations connected to each of the arms with a degree of freedom in translation in the plane of the device along the arms, said pivot articulations having a degree of freedom in translation advantageously comprising at least one beam that can be deformed in torsion, said pivot articulations having rotation axes at least parallel to each other such that, during translational displacement of the first parts and/or the second parts, the arms pivot relative to each other in opposite directions.

11. Device according to claim 9 or 10, comprising at least two guiding means, the rotation axes of the two guiding means advantageously intersecting each other.

12. Capacitive detection device comprising at least one device according to one of claims 1 to 11.

13. Actuator comprising at least one device according to one of claims 1 to 11, in which the mobile part is for example suspended from the fixed part by a pivot articulation.

14. Micromirror device comprising at least one actuator according to claim 13, in which the mobile support comprises a second face opposite the first face, comprising a reflecting surface forming a mirror.

15. Gyrometer comprising at least one device according to one of claims 1to 11, forming an actuator and/or a detection device.

16. Method of manufacturing a device according to one of claims 1 to 11, starting from a first substrate comprising at least one first layer made of a thick electrically conducting material, comprising the following steps:
a) formation of a sacrificial layer (710, 802) on the first layer made of an electrically conducting material (706, 800),
b) formation of first trenches in the first sacrificial layer (710, 802) as far as the first layer made of an electrically conducting material (706, 800) so as to form islands of the second sacrificial layer (710, 802),
c) formation of a second layer of electrically conducting material (712, 804) on the first sacrificial layer (710, 802) and in the first trenches, advantageously by epitaxial growth;
d) structuring of said second layer made of an electrically conducting material (712, 804) so as to form second trenches at least partly opening up on islands of a second sacrificial layer, the element thus formed comprising first portions of the second layer of electrically conducting material (712, 804) in contact with the first layer of electrically conducting material (706, 800) and that will form second electrodes and second portions of the second layer of electrically conducting material (712, 804) in contact with islands of the second sacrificial layer, that will form the first electrodes,
e) partial etching of the first portions,
f) release the structure.

17. Fabrication method according to claim 16, in which in step d), the first electrodes are formed by etching stopped on the islands of the second sacrificial layer and the second electrodes are formed by said etching stopped in time between islands of the second sacrificial layer or beyond in the direction of etching and/or in which step d) comprises the formation of a hard mask (714, 806) on the second layer of electrically conducting material (712, 804), structuring of said hard mask (714, 806) at the locations of the second portions, and the formation of a mask made of a photosensitive resin (716) at the locations of the first portions, and/or said method comprises a step between step e) and step f) to fabricate a second substrate (810) provided with a cavity (812), assembly of the second substrate (810) with the first substrate such that the first and second portions are facing the cavity (812) and fabrication of third trenches in the first substrate starting from the back face and as far as the first sacrificial layer (802) so as to delimit the mobile part, said method advantageously comprising a step to assemble a cover (808) on the second substrate.

18. Fabrication method according to claim 16 or 17, in which the first substrate is a silicon on insulator substrate, the fabrication method comprising a step before the first step a) in which fourth trenches (708) are formed in the first layer made of an electrically conducting material (706) as far as an oxide layer (704) in the first substrate so as to delimit the mobile part, and in which in step a), the first sacrificial layer (710) is formed on the first layer made of an electrically conducting material (706) so as to cover the first layer made of an electrically conducting material (706) and to at least close off the fourth trenches (708).
